(19) Europäisches Patentamt / European Patent Office / Office européen des brevets

(11) **EP 2 903 040 B1**

(12) **EUROPEAN PATENT SPECIFICATION**

(45) Date of publication and mention
of the grant of the patent:
**12.07.2017 Bulletin 2017/28**

(51) Int Cl.:
***H01L 33/50*** *(2010.01)*   *C09K 11/02* *(2006.01)*

(21) Application number: **14003791.2**

(22) Date of filing: **11.11.2014**

(54) **Wavelength conversion member**

Wellenlängenumsetzungselement

Élément de conversion de longueur d'onde

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.01.2014 JP 2014014692**

(43) Date of publication of application:
**05.08.2015 Bulletin 2015/32**

(73) Proprietors:
 • **Sharp Kabushiki Kaisha
   Sakai City, Osaka 590-8522 (JP)**
 • **National Institute for Materials Science
   Ibaraki 305-0047 (JP)**

(72) Inventors:
 • **Yoshimura, Kenichi
   Osaka-shi, Osaka, 545-8522 (JP)**
 • **Fukunaga, Hiroshi
   Osaka-shi, Osaka, 545-8522 (JP)**
 • **Harada, Masamichi
   Osaka-shi, Osaka, 545-8522 (JP)**
 • **Annen, Kazunori
   Osaka-shi, Osaka, 545-8522 (JP)**

 • **Hirosaki, Naoto
   Tsukuba-shi, Ibaraki, 305-0047 (JP)**
 • **Uchikoshi, Tetsuo
   Tsukuba-shi, Ibaraki, 305-0047 (JP)**

(74) Representative: **Müller Hoffmann & Partner
   Patentanwälte mbB
   St.-Martin-Strasse 58
   81541 München (DE)**

(56) References cited:
 **EP-A1- 2 314 659      WO-A1-2007/148253
 WO-A1-2013/144777    WO-A2-2006/072849
 DE-A1-102005 023 134  DE-A1-102010 042 217
 JP-A- H0 745 189        JP-A- 2011 168 627
 JP-A- 2013 035 953**

 • **TAKUYA KITABATAKE; TETSUO UCHIKOSHI;
 FUMIO MUNAKATA; YOSHIO SAKKA; NAOTO
 HIROSAKI: "Optical and adhesive properties of
 composite silica-impregnated Ca-u-SiAION:Eu
 phosphor films prepared on silica glass
 substrates", JOURNAL OF THE EUROPEAN
 CERAMIC SOCIETY, vol. 32, 2012, pages
 1365-1369, XP002740365,**

## Description

BACKGROUND

1. Field

The present disclosure relates to a wavelength conversion member and a light-emitting device including the wavelength conversion member. The present disclosure also relates to a method for producing a wavelength conversion member.

2. Description of the Related Art

In recent years, a light-emitting device has been developed that is a combination of a semiconductor light-emitting element such as a light-emitting diode (LED) and a wavelength conversion member (such as a fluorescent material). Such light-emitting devices have advantages of having a small size and having a lower power consumption than incandescent lamps. Accordingly, the light-emitting devices are put into practical use as light sources for various display devices and illumination devices.

Japanese Unexamined Patent Application Publication No. 10-163535 (published on June 19, 1998) discloses a light-emitting device that emits pseudo-white light. This light-emitting device is constituted by a combination of (i) a blue LED and (ii) a fluorescent material that is excited by blue light from the blue LED and converts the wavelength of the blue light to thereby emit yellow light. This document discloses three materials in which particles of the fluorescent material are dispersed: epoxy resin, acrylic resin, and water glass.

In recent years, it has been studied that, in such light-emitting devices, semiconductor lasers and the like having a higher luminous flux density than blue LEDs and the like are used as semiconductor light-emitting elements serving as excitation light sources. In addition, it has been studied that light that has a shorter wavelength than blue light is used as excitation light. In such cases, resin serving as a material in which fluorescent materials are dispersed is degraded by heat or light. In order to address such a problem and to provide light-emitting devices having high reliability and long longevity, various techniques have been proposed.

Japanese Unexamined Patent Application Publication No. 2003-258308 (published on September 12, 2003) discloses a white illumination light source. This white illumination light source is constituted by a combination of (i) a blue LED and (ii) a wavelength conversion member in which $Y_3Al_5O_{12}$-based (garnet-based) fluorescent material that is excited by light from the blue LED and emits yellow fluorescence is dispersed in glass having a softening point of 500°C or more.

Japanese Unexamined Patent Application Publication No. 2011-168627 (published on September 1, 2011) and Takuya Kitabatake, Tetsuo Uchikoshi, Fumio Munakata, Yoshio Sakka, Naoto Hirosaki, "Optical and adhesive properties of composite silica-impregnated Ca-α-SiAlON:Eu2+ phosphor films prepared on silica glass substrates", Journal of the European Ceramic Society 32 (2012), pp. 1365-1369 disclose methods of forming a wavelength conversion member excellent in terms of light emission properties, thermal stability, and chemical stability. In these methods of the documents, a fluorescent film including an aggregate of fluorescent particles is formed on a glass substrate by electrophoresis and a light-transmissive substance composed of glass is subsequently formed in gaps in the aggregate of the fluorescent particles.

JP H07 45189 A discloses a glass substrate with a phosphor layer in which phosphor particles are dispersed in an oxide binder.

WO 2013/144777 A1 discloses a porous phosphor layer supported by a glass substrate and containing phosphor grains sintered together and an inorganic transparent silicate binder substantially filling spaces in the porous phosphor layer.

DE 10 2010 042217 A1 discloses an optoelectronic semiconductor device with a phosphor which is applied to a conversion element. The conversion element has a substrate made of ceramic, which is applied to a glass matrix.

SUMMARY

However, none of the above-described documents discloses or suggests configurations that allow bonding of an aggregate of fluorescent particles to a substrate. Thus, fluorescent films become easily separated from substrates and, to date, there has been no wavelength conversion member having a sufficiently high mechanical strength.

The present disclosure can provide a wavelength conversion member having an enhanced mechanical strength.

According to an aspect of the present disclosure, there is provided a wavelength conversion member including a substrate and a fluorescent film that is disposed on the substrate and emits fluorescence upon reception of excitation light, wherein the fluorescent film includes an aggregate of a plurality of fluorescent particles, the aggregate being formed as a result of contact among the fluorescent particles, and a glass material filling gaps between the fluorescent particles in the aggregate, and a total volume of a volume of the glass material and a volume of the fluorescent particles in the fluorescent film is equal to or less than an envelope volume of the aggregate in the fluorescent film.

According to another aspect of the present disclosure, there is provided a light-emitting device including the above-described wavelength conversion member, and an excitation light source configured to apply the excitation light to the wavelength conversion member.

According to another aspect of the present disclosure, there is provided a method for producing a wavelength conversion member including a substrate and a fluorescent film that is disposed on the substrate and emits fluorescence upon reception of excitation light, the fluorescent film including an aggregate of a plurality of fluorescent particles, the aggregate being formed as a result of contact among the fluorescent particles, and a glass material filling gaps between the fluorescent particles in the aggregate, the method including depositing the aggregate onto the substrate; filling the gaps with a precursor of the glass material; and heating the precursor to form the glass material, wherein the wavelength conversion member is produced such that a total volume of a volume of the glass material and a volume of the fluorescent particles in the fluorescent film is equal to or less than an envelope volume of the aggregate in the fluorescent film.

## BRIEF DESCRIPTION OF THE DRAWINGS

Fig. 1 is a schematic sectional view illustrating a structure of a wavelength conversion member according to a first embodiment of the present disclosure;

Fig. 2 illustrates a production example for depositing fluorescent particles onto a substrate in the first embodiment of the present disclosure;

Fig. 3A is a SEM image obtained by capturing the surface of a fluorescent film in an Example of the present disclosure, and Fig. 3B illustrates a result of identification of a fluorescent material portion and a glass portion, the result being obtained with a cross-sectional EDX;

Fig. 4 illustrates another production example for depositing fluorescent particles onto a substrate in the first embodiment of the present disclosure;

Fig. 5A is a SEM image obtained by capturing the surface of a fluorescent film in a Comparative example, and Fig. 5B illustrates a result of identification of a fluorescent material portion and a glass portion, the result being obtained with a cross-sectional EDX;

Figs. 6A to 6C illustrate steps in Comparative examples: Fig. 6A illustrates a step of dropping a sol-gel solution on a substrate, Fig. 6B illustrates a step of drying the sol-gel solution on the substrate to form a precursor of a glass material, and Fig. 6C illustrates a step of firing the precursor of the glass material to form the glass material;

Figs. 7A to 7C illustrate steps in Examples of the present disclosure: Fig. 7A illustrates a step of dropping a sol-gel solution on a substrate, Fig. 7B illustrates a step of drying the sol-gel solution on the substrate to form a precursor of a glass material, and Fig. 7C illustrates a step of firing the precursor of the glass material to form the glass material;

Fig. 8 summarizes production conditions and evaluation results of wavelength conversion members in Examples in the first embodiment of the present disclosure;

Fig. 9 illustrates an example of the configuration of a test device used for evaluating wavelength conversion members according to the first embodiment of the present disclosure;

Figs. 10A and 10B illustrate results in Example 1 of the present disclosure: Fig. 10A is a graph of the emission spectrum of fluorescence and Fig. 10B is a graph of the emission spectrum of excitation light;

Figs. 11A and 11B illustrate results in the first embodiment of the present disclosure: Fig. 11A is a graph indicating the dependency of excitation light conversion efficiency of a wavelength conversion member on the thickness of a fluorescent film; and Fig. 11B is a graph indicating the dependency of excitation light conversion efficiency of a wavelength conversion member on a value obtained by dividing the thickness of the fluorescent film by the particle size of fluorescent particles;

Fig. 12 is a sectional view of a light-emitting device according to a second embodiment of the present disclosure;

Fig. 13 is a graph illustrating the emission spectrum of a light-emitting device according to a third embodiment of the present disclosure; and

Fig. 14 is a graph illustrating the emission spectrum of a light-emitting device according to a fourth embodiment of the present disclosure.

## DESCRIPTION OF THE EMBODIMENTS

First embodiment

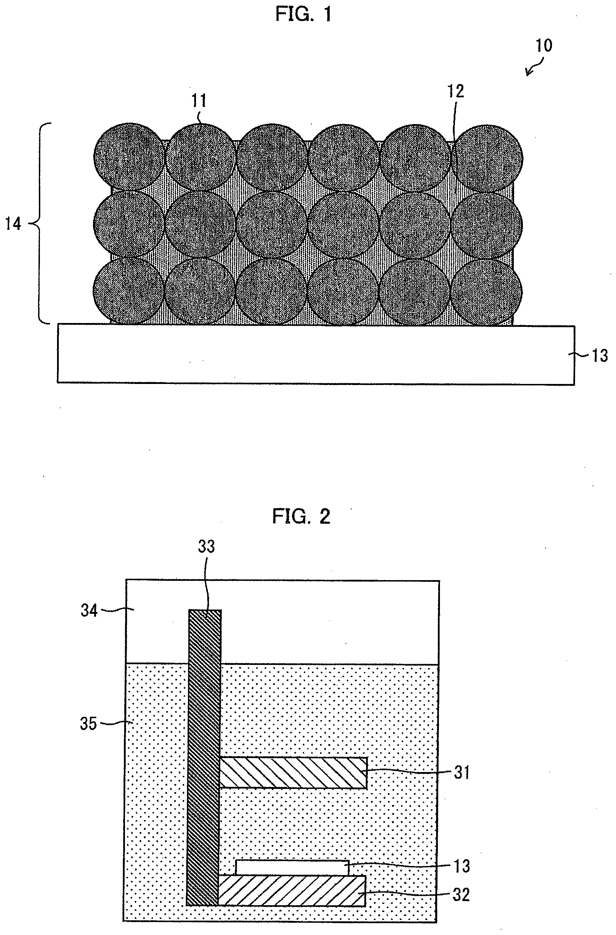

Hereinafter, a first embodiment according to the present disclosure will be described with reference to Figs. 1 to 11B.

The inventors of the present application repeatedly performed production and evaluation of trial products of a wavelength conversion member for the purpose of enhancing the mechanical strength of a wavelength conversion member. As a result, the inventors have newly found the following finding: by producing a wavelength conversion member such that fluorescent particles are deposited at a very high density on a substrate, a wavelength conversion member having a high mechanical strength can be provided.

As described below, a wavelength conversion member according to an embodiment of the present disclosure has a structure that is highly unexpected from common general technical knowledge. Accordingly, the structure of a wavelength conversion member according to an embodiment of the present disclosure cannot be easily conceived on the basis of the above-described documents.

Configuration of wavelength conversion member 10

Fig. 1 is a schematic sectional view illustrating a structure of a wavelength conversion member 10 in the present embodiment. The wavelength conversion member 10 includes fluorescent particles 11, a glass material 12, and a substrate 13. The fluorescent particles 11 and the glass material 12 are disposed on the substrate 13. A fluorescent film 14 that includes the fluorescent particles 11 and the glass material 12 is formed on the substrate 13.

In the wavelength conversion member 10, the fluorescent particles 11 are excited by being irradiated with excitation light. The fluorescent particles 11 having been excited emit fluorescence having a longer wavelength than the excitation light. That is, the wavelength conversion member 10 has a function of converting excitation light into fluorescence.

The fluorescent particles 11 are formed of, for example, a material such as an oxynitride fluorescent material or a nitride fluorescent material. The details of the fluorescent particles 11 (such as material and production method) will be described below. The fluorescent particles 11 form an aggregate including at least one fluorescent particle layer.

In the present embodiment, the aggregate of the fluorescent particles 11 denotes a mass of aggregated fluorescent particles 11 formed by self-organization caused by contact among the fluorescent particles 11. The phrase "contact among the fluorescent particles 11" encompasses a case (i) where the fluorescent particles 11 come into direct contact with one another and a case (ii) where the fluorescent particles 11 are covered with a cover material and the fluorescent particles 11 come into indirect contact with one another via the cover material. Thus, it can also be understood that the aggregate of the fluorescent particles 11 denotes a mass of aggregated fluorescent particles 11 formed by self-organization through deposition of a plurality of the fluorescent particles 11 (that is, formation of a layer of the plurality of the fluorescent particles 11).

As described below, gaps in the aggregate of the fluorescent particles 11 are filled with the glass material 12. Before the gaps are filled with the glass material 12, the fluorescent particles 11 may be bonded together with a binder. The binder may be an organic material such as resin. The binder may be an inorganic substance.

In order to ensure a sufficiently high strength of the aggregate of the fluorescent particles 11, the binder may be the same substance as the glass material 12. On the other hand, in order to ensure a sufficiently high light extraction efficiency of the wavelength conversion member 10, the binder may be a substance that has a refractive index between that of the fluorescent particles 11 and that of the glass material 12.

The glass material 12 is a light-transmissive glass material that fills gaps in the fluorescent particle aggregate. The glass material 12 may be oxide glass. The glass material 12 may be referred to as a light-transmissive substance.

In particular, the glass material 12 may be silica glass. By using silica glass as the glass material 12, high transparency, high thermal stability, and high chemical stability are achieved.

The glass material 12 fills gaps in the aggregate of the fluorescent particles 11 such that the total volume of the volume of the glass material 12 and the volume of the fluorescent particles 11 is not more than the envelope volume of the aggregate of the fluorescent particles 11.

That is, the total volume of the volume of the glass material 12 and the volume of the fluorescent particles 11 is equal to or less than the envelope volume of the aggregate of the fluorescent particles 11. The "envelope volume of the aggregate of the fluorescent particles 11" is defined as the minimum volume of an imaginary rectangular parallelepiped that contains all the fluorescent particles 11 present within the fluorescent film 14.

In the case where the above-described binder is a substance that is different from the glass material 12, the glass material 12 fills gaps in the aggregate of the fluorescent particles 11 such that the envelope volume of the glass material 12 is not more than the envelope volume of the aggregate of the fluorescent particles 11.

In this case, the envelope volume of the glass material 12 is equal to or less than the envelope volume of the aggregate of the fluorescent particles 11. The "envelope volume of the glass material 12" is defined as the minimum volume of an imaginary rectangular parallelepiped that contains the entirety of the glass material 12 filling gaps in the aggregate of the fluorescent particles 11.

The substrate 13 is provided to support the fluorescent particles 11 and the glass material 12. The material of the substrate 13 is not particularly limited and may be a material that tends not to absorb light and has a high heat-dissipation capability.

More specifically, in the case of providing a light-emitting device in which excitation light is reflected by the substrate 13, the material of the substrate 13 may be a metal such as A1, Ag, Pt, or Si. On the other hand, in the case of providing a light-emitting device in which excitation light passes through the substrate 13, the material of the substrate 13 may be silica glass, Pyrex (registered trademark) glass, sapphire, GaN, or the like.

The fluorescent film 14 contains the fluorescent particles 11 at a high density. Specifically, the fluorescent film 14 contains the fluorescent particles 11 at a volume density of about 30 to about 70 vol%. Accordingly, the wavelength conversion member 10 of the present embodiment contains the fluorescent material at a very high density, compared with typical wavelength conversion members in which a fluorescent material is uniformly dispersed at a low density in a glass material.

The glass material 12 fills gaps in the aggregate of the fluorescent particles 11 such that the total volume of the volume of the glass material 12 and the volume of the fluorescent particles 11 is not more than the envelope volume of the aggregate of the fluorescent particles 11. Thus, an excess amount of the glass material 12 is not contained. As a result, it is suppressed that the fluorescent particles 11 become separated from the substrate 13 due to the presence of an excess amount of the glass material 12. Thus, the adhesion between the fluorescent particles 11 and the substrate 13 is high, compared with existing wavelength conversion members.

The configuration of the wavelength conversion member 10 is provided by (i) forming a film of the aggregate of the fluorescent particles 11 on the substrate 13 within liquid and subsequently (ii) filling gaps present between the fluorescent particles 11 with a sol-gel solution containing a precursor of the glass material 12. The method for producing the wavelength conversion member 10 will be described in detail below.

In the case where an excess amount of the glass material 12 fills the gaps, the tendency of the fluorescent film 14 to separate from the substrate 13 increases as the thickness of the fluorescent film 14 decreases and the particle size of the fluorescent particles 11 increases. In other words, as the number of the fluorescent particles 11 deposited onto the substrate 13 decreases and the particle size of the fluorescent particles 11 increases, the tendency of the fluorescent film 14 to separate from the substrate 13 increases.

This is probably because, in the case where a small number of the fluorescent particles 11 having a large particle size are deposited onto the substrate 13, the precursor of the glass material 12 easily spreads in the interface between the fluorescent particles 11 and the substrate 13.

That is, in the case where an excess amount of the glass material 12 fills the gaps, a film of the precursor of the glass material 12 is probably formed between the aggregate of the fluorescent particles 11 and the substrate 13. This increases the tendency of the fluorescent film 14 to separate from the substrate 13.

Method for producing wavelength conversion member 10

A method for producing the wavelength conversion member 10 of the present embodiment includes the following three steps. Hereinafter, these steps will be described.

    First step: step of preparing slurry
    Second step: step of depositing the fluorescent particles 11 onto the substrate 13
    Third step: step of filling gaps in the aggregate of the fluorescent particles 11 with the glass material 12

First step: step of preparing slurry

The fluorescent particles 11 are added to an organic solvent such as ethanol or methanol such that the fluorescent particles 11 are distributed in the organic solvent at a volume density of 0.05 to 3 vol%. At this time when the fluorescent particles 11 are added to the organic solvent, a metal alkoxide such as tetraethyl orthosilicate (TEOS) or tetramethyl orthosilicate (TMOS) may be added to or dissolved in the organic solvent.

In such a case where a metal alkoxide is dissolved in the organic solvent, acid or base serving as a catalyst is dissolved together with the metal alkoxide in the organic solvent. By adding the metal alkoxide and the catalyst to the organic solvent, the metal alkoxide reacts and hydrolysis and polymerization occur, so that the surfaces of the fluorescent particles 11 are coated with a precursor of a metal oxide.

The "precursor of a metal oxide" denotes a substance provided by hydrolysis and polycondensation of a metal alkoxide. In the above-described case where the metal alkoxide is a silicon metal alkoxide such as TEOS or TMOS, the metal oxide is silica.

In another case where the metal alkoxide is a titanium metal alkoxide, the metal oxide is titania. In another case where the metal alkoxide is an aluminum metal alkoxide, the metal oxide is alumina. In this way, the metal oxide depends on a metal atom contained in the metal alkoxide.

In the first step, slurry in which the fluorescent particles 11 are dispersed is prepared. The reaction time for the metal alkoxide may be appropriately determined depending on the type of the metal alkoxide and the type of the catalyst. The amount of the metal alkoxide and the amount of the catalyst may be appropriately determined depending on the amount of the fluorescent particles 11.

In order to promote hydrolysis of the metal alkoxide, water may be added to the organic solvent. In the case where the amount of the metal alkoxide is very small, water in the air may be used, the water dissolving in the organic solvent during reaction in the organic solvent.

Second step: step of depositing fluorescent particles 11 onto substrate 13

In the slurry prepared by the first step, the substrate 13 is immersed. Thus, the fluorescent particles 11 are deposited onto the substrate 13, so that the aggregate of the fluorescent particles 11 is formed in the form of a film on the substrate 13. At the time when the second step is completed, gaps are present in the aggregate of the fluorescent particles 11.

In the case where the surfaces of the fluorescent particles 11 are coated with the precursor of the metal oxide, the precursor of the metal oxide serves as a binder that bonds the fluorescent particles 11 together. Thus, the fluorescent particles 11 are bonded together.

In the case where a large amount of the fluorescent particles 11 are dispersed in the slurry, the fluorescent particles 11 are naturally deposited by gravity onto the substrate 13. On the other hand, electrophoresis may be employed such that application of an electric field to the slurry causes deposition of the fluorescent particles 11 onto the substrate 13.

In particular, in the case where the fluorescent particles 11 have a small particle size, in order to deposit the fluorescent particles 11 at a high density, electrophoresis may be employed to deposit the fluorescent particles 11 onto the substrate 13. In the case where the substrate 13 has a low conductivity, in order to employ electrophoresis, the substrate 13 may be coated with a conductive substance.

After the fluorescent particles 11 are deposited onto the substrate 13, the fluorescent particles 11 and the substrate 13 may be heated once at a temperature of 150°C or more and 1000°C or less. In the case where the surfaces of the fluorescent particles 11 are coated with the precursor of the metal oxide, as a result of heating of the fluorescent particles 11 and the substrate 13, the fluorescent particles 11 are bonded together.

In the case where the substrate 13 is coated with a conductive substance composed of an organic substance such as polypyrrole, before the step of filling gaps in the aggregate of the fluorescent particles 11 with the glass material 12 (that is, the third step) is performed, the organic conductive substance may be removed. Specifically, this removal may be achieved by heating the fluorescent particles 11 and the substrate 13 at a temperature of 400°C or more.

Third step: step of filling gaps in aggregate of fluorescent particles 11 with glass material 12

At the time when the second step is completed, gaps are present in the aggregate of the fluorescent particles 11. In addition, the adhesion between the fluorescent particles 11 and the substrate 13 is not sufficiently high. Accordingly, in the third step, in order to enhance the strength of the wavelength conversion member 10, the gaps in the aggregate of the fluorescent particles 11 are filled with the glass material 12.

Specifically, a metal alkoxide such as TEOS or TMOS is dissolved in an organic solvent such as ethanol or methanol. Subsequently, a catalyst such as acid or base and water for promoting hydrolysis are added to the organic solvent. Thus, a sol-gel solution is prepared.

In the third step, the concentrations of the metal alkoxide and the catalyst relative to the organic solvent are adjusted to be higher than, in the first step, the concentrations of the metal alkoxide and the catalyst relative to the organic solvent.

The above-described sol-gel solution is dropped on the substrate 13, so that the sol-gel solution permeates the gaps in the aggregate of the fluorescent particles 11. Thus, the gaps are filled with the precursor of the glass material 12. The "precursor of the glass material 12" denotes a substance that is a polycondensate of a metal alkoxide, a part of or all alkyl groups of which are substituted with hydroxyl groups.

At this time, the amount of the sol-gel solution dropped may be accurately controlled with a micropipette or the like, so that the volume of the glass material 12 finally formed is adjusted. Specifically, the amount of the sol-gel solution dropped is adjusted such that the total volume of the volume of the glass material 12 and the volume of the fluorescent particles 11 is not more than the envelope volume of the aggregate of the fluorescent particles 11.

After the sol-gel solution is dropped on the substrate 13, the substrate 13 may be left at rest in a vacuum atmosphere to thereby promote permeation of the sol-gel solution into the gaps in the aggregate of the fluorescent particles 11.

Subsequently, the sol-gel solution is turned into glass to thereby form the glass material 12. Specifically, the substrate 13 on which the sol-gel solution has been dropped is heated at a temperature of 200°C or more and 1000°C or less. The precursor of the glass material 12 is shrunken by heating. Thus, in consideration of this shrinkage, the glass material 12 is formed such that the total volume of the volume of the glass material 12 and the volume of the fluorescent particles 11 is not more than the envelope volume of the aggregate of the fluorescent particles 11.

Material of fluorescent particles 11

The fluorescent particles 11 are constituted by one or more fluorescent materials. Examples of these fluorescent materials include the following known materials.

1: aluminate fluorescent materials such as Ce-activated $Y_3(Al,Ga)_5O_{12}$
2: silicate fluorescent materials such as Eu-activated $(Ba,Sr)_2SiO_4$
3: oxynitride fluorescent materials such as Eu-activated $\alpha$-SiAlON fluorescent material, Eu-activated $\beta$-SiAlON fluorescent material, Ce-activated $\alpha$-SiAlON fluorescent material, Ce-activated $\beta$-SiAlON fluorescent material, Ce-activated JEM fluorescent material, and Ce-activated CALSON fluorescent material
4: nitride fluorescent materials such as Eu-activated $CaAlSiN_3$ fluorescent material, Eu-activated $M_2Si_5N_8$ fluorescent material (M = Ca, Ba, Sr), and Ce-activated $La_3Si_6N_{11}$ fluorescent material

In the aggregate of the fluorescent particles 11, the glass material 12 is formed so as to fill gaps in the aggregate of the fluorescent particles 11. In order to form the glass material 12, a high-temperature process at 200°C or more may be performed.

Accordingly, the material of the fluorescent particles 11 may be a fluorescent material that has high stability, compared with existing cases where fluorescent particles are dispersed in resin materials such as silicone.

Among the above-described fluorescent materials, oxynitride fluorescent materials and nitride fluorescent materials, which are highly heat resistant, may be used.

The fluorescent particles 11 may have a particle size of 1 $\mu$m or more and 50 $\mu$m or less. When such a particle-size range is satisfied, the fluorescent particles 11 have a high light emission efficiency and handling of the fluorescent particles 11 is facilitated.

When the fluorescent particles 11 are prepared so as to have a particle size of 5 $\mu$m or more, the fluorescent particles 11 can have very high crystallinity and the fluorescent particles 11 can have an even higher light emission efficiency. When the fluorescent particles 11 are prepared so as to have a particle size of 25 $\mu$m or less, in the step of forming the fluorescent film 14, handling of the fluorescent particles 11 is particularly facilitated and the fluorescent film 14 having a more uniform thickness can be formed.

Accordingly, the fluorescent particles 11 may be prepared so as to have a particle size of 5 $\mu$m or more and 25 $\mu$m or less. When such a particle-size range is satisfied, the wavelength conversion member 10 has a very high utilization efficiency of excitation light. Accordingly, a light-emitting device having a high light emission efficiency can be provided.

Method for producing fluorescent particles 11

Hereinafter, two examples of a method for producing the fluorescent particles 11 will be described.

Production example 1-1: Eu-activated $\alpha$-SiAlON fluorescent material

Production example 1-1 is intended to produce a Eu-activated $\alpha$-SiAlON fluorescent material represented by a composition formula of $(Ca_x, Eu_y)$ $(Si_{12-(m+n)}Al_{m+n})$ $(O_nN_{16-n})$ where x = 1.8, y = 0.075, m = 3.75, and n = 0.05.

Specifically, raw material powders are weighed so as to achieve the following composition: 59.8 mass% of $\alpha$ silicon nitride powder, 24.3 mass% of aluminum nitride powder, 13.9 mass% of calcium nitride powder, 0.9 mass% of europium oxide powder, and 1.1 mass% of europium nitride powder.

Subsequently, the raw material powders are mixed with a mortar and pestle composed of silicon nitride sinter for 10 or more minutes. As a result, a powder aggregate is obtained. The europium nitride powder is synthesized by nitriding metal europium in ammonia.

Subsequently, the powder aggregate is sifted through a sieve having an opening of 250 $\mu$m. The obtained powder aggregate is charged into a crucible having a diameter of 20 mm and a height of 20 mm and formed of boron nitride.

The steps of weighing, mixing, and shaping the powders are all performed within a glove box in which a nitrogen atmosphere having a water content of 1 ppm or less and an oxygen content of 1 ppm or less can be maintained.

Subsequently, the crucible is placed in a pressure electric furnace of graphite resistance heating type. A nitrogen gas having a purity of 99.999 vol% is introduced into the pressure electric furnace so as to adjust the pressure to 1 MPa. The temperature of the pressure electric furnace is increased to 1800°C at a temperature increase rate of 500°C/h and further kept at 1800°C for 2 hours. Thus, the crucible is heated and, as a result, a fluorescent material sample is obtained.

Subsequently, the fluorescent material sample is ground with an agate mortar and treated with a mixed acid (50% hydrofluoric acid and 70% nitric acid are mixed in a ratio of 1:1) at 60°C. The fluorescent material sample is washed with pure water and then sifted through a sieve having an opening of 10 $\mu$m, so that particles having a small particle size are removed. Thus, the fluorescent particles 11 are obtained as a fluorescent powder.

The fluorescent particles 11 were measured by XRD (X-ray diffraction) using Cu-K$_\alpha$ radiation. As a result, it was confirmed that the fluorescent particles 11 had an $\alpha$-SiAlON crystal structure.

When the fluorescent particles 11 were irradiated with light having a wavelength of 365 nm emitted from a lamp, it was confirmed that the fluorescent particles 11 emitted orange light. In addition, the fluorescent particles 11 were measured by laser diffractometry and, as a result, found to have a particle size of 19 $\mu$m. Hereafter, the particle size of fluorescent particles 11 will be referred to as "d".

Production example 1-2: Eu-activated $\alpha$-SiAlON fluorescent material having smaller particle size

In Production example 1-2, the fluorescent particles having passed through the sieve having an opening of 10 $\mu$m in Production example 1-1 above (that is, fluorescent particles having a smaller particle size) are dispersed in 200 ml of pure water in a beaker. The beaker is left for an hour and then 100 ml of the supernatant fluid is removed.

Subsequently, to the beaker, 100 ml of pure water is added, so that the fluorescent particles are dispersed again in 200 ml of pure water. The beaker is left for an hour and then 100 ml of the supernatant fluid is removed. In this way, the step of dispersing fluorescent particles in 200 ml of pure water and then removing 100 ml of the supernatant fluid is further repeated 10 times.

After the step is repeated 10 times, the dispersion liquid in the beaker is dried. Thus, particles having a small particle size present in the supernatant fluid have been removed. As a result, the fluorescent particles 11 are obtained as a fluorescent powder that satisfies a predetermined particle-size range.

The fluorescent particles 11 were measured by XRD using Cu-K$_\alpha$ radiation. As a result, it was confirmed that the fluorescent particles 11 had an $\alpha$-SiAlON crystal

structure.

When the fluorescent particles 11 were irradiated with light having a wavelength of 365 nm emitted from a lamp, it was confirmed that the fluorescent particles 11 emitted orange light. In addition, the fluorescent particles 11 were measured by laser diffractometry and, as a result, found to have a particle size d of 6 $\mu$m.

Method for producing wavelength conversion member 10

Hereinafter, a method for producing the wavelength conversion member 10 will be described with reference to Examples 1 to 14.

Example 1

To 100 ml of ethanol, 0.5 g of the fluorescent particles 11 obtained in Production example 1-1 above, 93 $\mu$l of TEOS, and 30 $\mu$l of hydrochloric acid are added. The resultant ethanol solution is stirred for 24 hours to prepare a fluorescent-material-dispersed solution 35. At this time, TEOS is hydrolyzed, so that the surfaces of the fluorescent particles 11 are coated with a precursor of silica.

Fig. 2 illustrates a configuration used for depositing the fluorescent particles 11 onto the substrate 13 in this Example. After the substrate 13 is immersed in the fluorescent-material-dispersed solution 35, this configuration and a method specifically described below are employed to deposit the fluorescent particles 11 onto the substrate 13.

The fluorescent-material-dispersed solution 35 is placed within a beaker 34 having a volume of 100 ml. In the beaker 34, a jig is placed that has the following structure: 20 mm x 20 mm plates 31 and 32 are fixed to a support rod 33 having a length of 40 mm so as to be perpendicular to the support rod 33. On an upper surface of the plate 32, a 10 mm x 10 mm substrate 13 formed of Pyrex (registered trademark) glass is placed.

After the substrate 13 is left in the beaker 34 for a minute, the support rod 33 is slowly withdrawn to thereby obtain the substrate 13 onto which an aggregate of the fluorescent particles 11 has been deposited to a desired thickness. The dimensions of the substrate 13, the plates 31 and 32, the support rod 33, and the beaker 34 are not limited to the above-described dimensions and can be appropriately changed in accordance with the production conditions and the like.

The thickness of the aggregate of the fluorescent particles 11 to be deposited onto the substrate 13 mainly depends on the concentration of the fluorescent material relative to ethanol. This thickness also depends on the time for which the substrate 13 is left in the beaker 34 and the distance between the plates 31 and 32. In Example 1, the time for which the substrate 13 is left in the beaker 34 is set to 1 minute and the distance between the plates 31 and 32 is set to 20 mm.

The substrate 13 onto which the aggregate of the fluorescent particles 11 has been deposited is heated in the air at 500°C for 2 hours, so that the fluorescent particles 11 are bonded together.

Subsequently, in another beaker (not the beaker 34), to a mixed solution of 4 ml of ethanol and 6 ml of TEOS, 3 ml of pure water and 1 ml of hydrochloric acid are slowly added. Thus, a sol-gel solution is prepared.

Subsequently, 4 $\mu$l of the sol-gel solution is dropped with a micropipette onto the substrate 13. After that, the substrate 13 is dried in a vacuum within a vacuum chamber having been evacuated with a rotary pump.

The substrate 13 onto which the sol-gel solution has been dropped is thus placed in a vacuum, so that the sol-gel solution is dried and permeation of the sol-gel solution into gaps in the aggregate of the fluorescent particles 11 can also be promoted.

After the sol-gel solution is dried, finally, the substrate 13 is taken out into the air and heated again at 500°C for 2 hours, so that the fluorescent film 14 is formed on the substrate 13. Thus, the above-described wavelength conversion member 10 is obtained.

In this Example, the fluorescent film 14 was measured with a laser microscope (manufactured by Keyence Corporation) and was found to have a thickness of 44 $\mu$m. Hereafter, the thickness of a fluorescent film 14 will be referred to as "D".

A value is mentioned here that is obtained by dividing the thickness D of the fluorescent film 14 by the particle size d of the fluorescent particles 11, that is, the value of a ratio of D:d. Hereafter, the value of the ratio of D:d will be referred to as R = D/d. The value of R can be used as an index indicating the number of the fluorescent particles 11 disposed on the substrate 13.

As described in Production example 1-1 above, in this Example, d = 19 $\mu$m.

Accordingly, in this Example,

$$R = 44 \ \mu m/19 \ \mu m = 2.3.$$

In addition, in order to evaluate adhesion between the fluorescent film 14 and the substrate 13, a tape test was performed. Specifically, an adhesive tape having an adhesion of 3.9 N/10 mm was attached to the surface of the fluorescent film 14; and, at the time when the adhesive tape was then detached, it was determined as to whether the fluorescent film 14 was separated from the substrate 13.

In this Example, no separation of the fluorescent film 14 from the substrate 13 was observed in the tape test. Accordingly, it has been demonstrated that the adhesion between the fluorescent film 14 and the substrate 13 is sufficiently high.

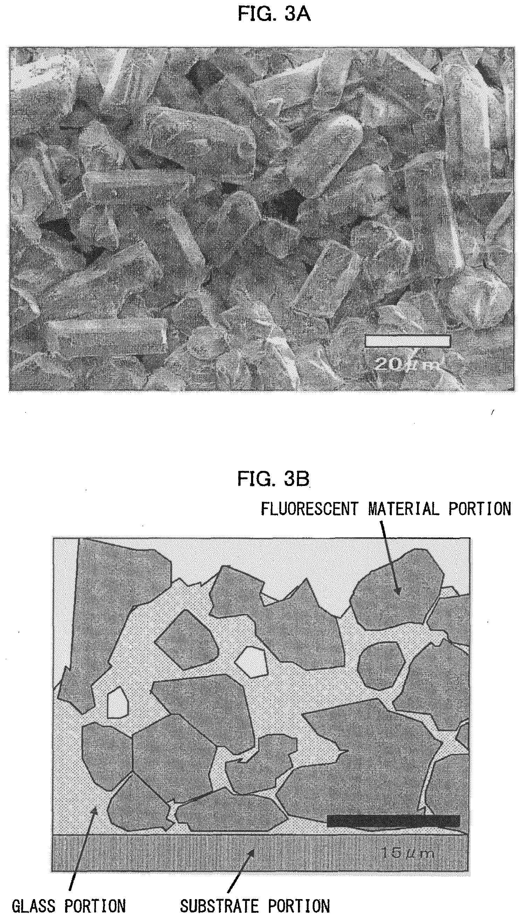

Fig. 3A is a SEM (scanning electron microscope) image obtained by capturing the surface of the fluorescent film 14 in this Example with a SEM apparatus (manufactured by Keyence Corporation). Fig. 3A indicates that the wavelength conversion member 10 produced in this Example contains the fluorescent particles 11 at a high density.

Fig. 3B illustrates a cross section of the wavelength conversion member 10 of this Example obtained as a result of a measurement with a cross-sectional EDX (energy dispersive X-ray spectrometer), the cross section indicating two different portions that are a fluorescent material portion (that is, the fluorescent particles 11) and a glass portion (that is, the glass material 12).

The cross section of the wavelength conversion member 10 illustrated in Fig. 3B is obtained by the following process: the wavelength conversion member 10 is embedded in an epoxy resin and then the wavelength conversion member 10 embedded in the epoxy resin is cut with a cross section polisher (manufactured by JEOL Ltd.) using an Ar-ion beam. The cross-sectional EDX measurement was performed with an EDX detector (AMETEK Co., Ltd) included in the SEM apparatus.

In the result of the cross-sectional EDX measurement in Fig. 3B, the fluorescent material portion and the glass portion were individually identified such that (i) a portion that was found to have a high Ca content was defined as the fluorescent material portion and (ii) a portion that was found to have a high O content was defined as the glass portion. Another portion that was found to have a high Na content was defined as a substrate portion.

The result in Fig. 3B indicates that, in the wavelength conversion member 10 of this Example, gaps in the aggregate of the fluorescent particles 11 are filled with the glass material 12 composed of silica glass such that the total volume of the volume of the glass material 12 and the volume of the fluorescent particles 11 is not more than the envelope volume of the aggregate of the fluorescent particles 11.

Example 2

Example 2 is different from Example 1 only in the following two points.

    (i) The mass of the fluorescent particles 11 added to 100 ml of ethanol was set to 1 g.
    (ii) The amount of the sol-gel solution dropped on the substrate 13 with a micropipette was set to 8 $\mu$l.

Thus, except for these two points, a wavelength conversion member was produced under the same production conditions as in Example 1. Accordingly, as in Example 1, the fluorescent particles 11 obtained in Production example 1-1 above were used.

In this Example, the fluorescent film 14 was measured with a laser microscope (manufactured by Keyence Corporation) and was found to have a thickness D of 88 $\mu$m. The particle size d of the fluorescent particles 11 was the same as in Example 1 (that is, 19 $\mu$m).

Accordingly, in this Example,

$$R = 88 \ \mu m / 19 \ \mu m = 4.6.$$

In addition, as in Example 1, the tape test was performed. As a result, no separation of the fluorescent film 14 from the substrate 13 was observed. As in Example 1, the result of the cross-sectional EDX measurement indicates that gaps in the aggregate of the fluorescent particles 11 are filled with the glass material 12 such that the total volume of the volume of the glass material 12 and the volume of the fluorescent particles 11 is not more than the envelope volume of the aggregate of the fluorescent particles 11.

Example 3

Example 3 is different from Examples 1 and 2 above in that the fluorescent particles 11 obtained in Production example 1-2 were used.

In this Example, to 100 ml of ethanol, 0.5 g of the fluorescent particles 11 obtained in Production example 1-2 above, 93 $\mu$l of TEOS, and 30 $\mu$l of hydrochloric acid are added. The resultant ethanol solution is stirred for 24 hours to prepare a fluorescent-material-dispersed solution 35. At this time, TEOS is hydrolyzed, so that the surfaces of the fluorescent particles 11 are coated with a precursor of silica.

As in Fig. 2 described above, after the substrate 13 is immersed in the fluorescent-material-dispersed solution 35, the fluorescent particles 11 are settled onto the substrate 13. Unlike Example 1, in this Example, an electric field is applied between the plates 31 and 32. By using the electric field to increase the movement speed of the fluorescent particles 11, the fluorescent particles 11 can be quickly deposited onto the substrate 13, compared with Example 1.

In this Example, the fluorescent particles 11 are coated with the precursor of silica. In addition, hydrochloric acid is dropped and hence the ethanol solution is acidic. Accordingly, the surfaces of the fluorescent particles 11 are positively charged. Thus, by applying the electric field in a direction from the plate 31 to the plate 32, the movement speed of the fluorescent particles 11 is increased, so that the fluorescent particles 11 can be settled more quickly.

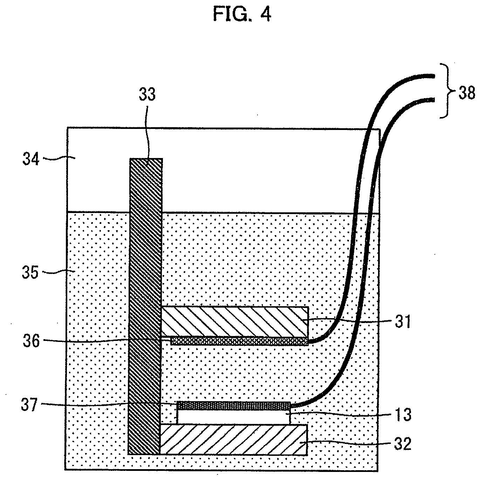

Fig. 4 illustrates a configuration used for depositing the fluorescent particles 11 onto the substrate 13 in this Example. As described below in detail, the configuration in Fig. 4 includes, in addition to the members in Fig. 2, a metal electrode 36, a conductive organic film 37, and lead wires 38.

In this Example, the metal electrode 36 that is a plate-shaped electrode formed of, for example, titanium is placed under the plate 31. The conductive organic film 37 formed of, for example, polypyrrole is formed on the surface of the substrate 13 by a coating process.

The substrate 13 is a 10 mm x 10 mm glass substrate. The conductive organic film 37 is formed on the surface of the substrate 13 by a coating process as in Japanese Unexamined Patent Application Publication No. 2011-168627 (published on September 1, 2011). Specifically, the substrate 13 is immersed in a solution prepared by adding ammonium peroxodisulfate and disodium 2,6-naphthalenedisulfonate to distilled water. Subsequently, pyrrole is dropped on the substrate 13 and the substrate 13 is left for 24 hours. The substrate 13 is taken out of the solution, washed with distilled water, and then dried. As a result of these procedures, the conductive organic film 37 is formed on the surface of the substrate 13.

The metal electrode 36 and the conductive organic film 37 are respectively connected via the lead wires 38 to an external constant-voltage power supply (not shown). A voltage applied by the constant-voltage power supply is, for example, 100 V.

In this Example, the metal electrode 36 is connected to the anode of the constant-voltage power supply and the conductive organic film 37 is connected to the cathode of the constant-voltage power supply, via the lead wires 38. Accordingly, by applying a voltage of 100 V between the metal electrode 36 and the conductive organic film 37, the electric field is applied in a direction from the plate 31 to the plate 32.

After the application of the electric field in a direction from the plate 31 to the plate 32 is kept for a minute, the support rod 33 is slowly withdrawn to thereby obtain the substrate 13 onto which an aggregate of the fluorescent particles 11 has been deposited to a desired thickness.

The substrate 13 onto which the aggregate of the fluorescent particles 11 has been deposited is heated in the air at 500°C for 2 hours, so that the fluorescent particles 11 are bonded together and the conductive organic film 37 is removed.

Subsequently, in another beaker (not the beaker 34), to a mixed solution of 4 ml of ethanol and 6 ml of TEOS, 3 ml of pure water and 1 ml of hydrochloric acid are slowly added. Thus, a sol-gel solution is prepared.

Subsequently, 2 $\mu$l of the sol-gel solution is dropped with a micropipette onto the substrate 13. A vacuum chamber is then evacuated with a rotary pump. Within this vacuum chamber, the substrate 13 is dried in a vacuum. The substrate 13 onto which the sol-gel solution has been dropped is thus placed in a vacuum, so that the sol-gel solution is dried and permeation of the sol-gel solution into gaps in the aggregate of the fluorescent particles 11 can also be promoted.

After the sol-gel solution is dried, finally, the substrate 13 is heated again in the air at 500°C for 2 hours. Thus, the above-described wavelength conversion member 10 is obtained.

In this Example, the fluorescent film 14 was measured with a laser microscope (manufactured by Keyence Corporation) and was found to have a thickness D of 26 $\mu$m. As described in Production example 1-2 above, in this Example, d = 6 $\mu$m.

Accordingly, in this Example,

$$R = 26 \ \mu m / 6 \ \mu m = 4.3.$$

In addition, as in Example 1, the tape test was performed. As a result, no separation of the fluorescent film 14 from the substrate 13 was observed. As in Example 1, the result of the cross-sectional EDX measurement indicates that gaps in the aggregate of the fluorescent particles 11 are filled with the glass material 12 such that the total volume of the volume of the glass material 12 and the volume of the fluorescent particles 11 is not more than the envelope volume of the aggregate of the fluorescent particles 11.

Comparative example 1

Comparative example 1 is a comparative example that corresponds to Example 1 above. Comparative example 1 is the same as Example 1 except that the amount of the sol-gel solution dropped on the substrate 13 with a micropipette is set to 20 $\mu$l. Thus, in terms of the other points, the wavelength conversion member 10 is produced under the same production conditions as in Example 1.

The aggregate of the fluorescent particles 11 obtained in Comparative example 1 became separated so easily that the wavelength conversion member 10 was difficult to handle in the optical measurements. As in Example 1, the tape test was performed. As a result, a portion (corresponding to an area of 80% or more) of the fluorescent film 14 became separated from the substrate 13.

The thickness of the fluorescent film 14 having become separated was measured with a laser microscope. As a result, the thickness was found to be non-uniform and considerably varied. Specifically, in the fluorescent film 14, a thick portion had a thickness of about 90 $\mu$m and a thin portion had a thickness of about 50 $\mu$m.

In addition, the fluorescent film 14 having become separated was subjected to the surface observation with the SEM and the cross-sectional EDX measurement as in Example 1.

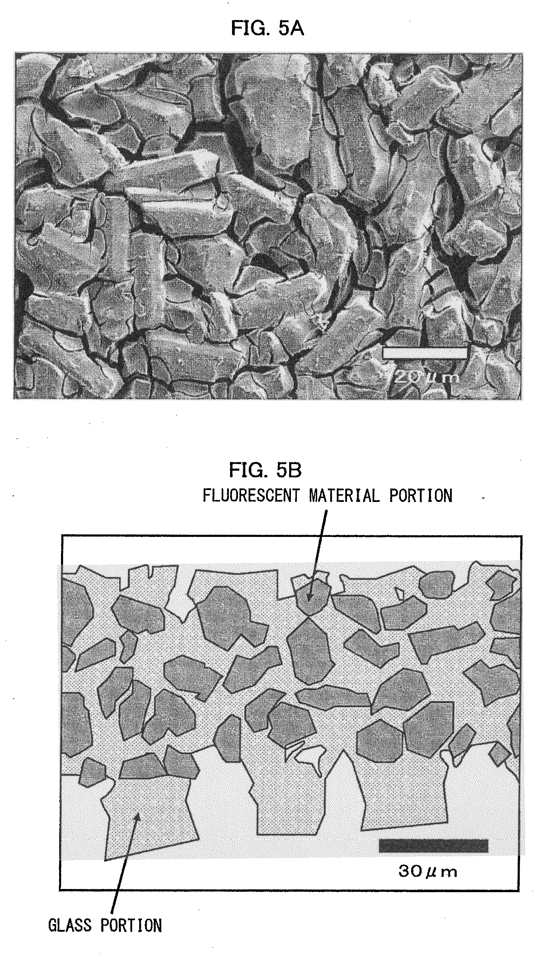

Fig. 5A is a SEM image of the surface of the fluorescent film 14 in this Comparative example. Fig. 5A indicates that, in the wavelength conversion member 10 in this Comparative example, the surfaces of the fluorescent particles 11 are covered with a thick film and the thick film has cracks.

Fig. 5B illustrates a cross section of the wavelength conversion member 10 of this Comparative example obtained as a result of the cross-sectional EDX measurement, the cross section indicating two different portions that are a fluorescent material portion and a glass portion. Fig. 5B indicates that the glass portion (that is, the glass material 12) forms protrusions on the surface of the fluorescent material portion (that is, the aggregate of the fluorescent particles 11) so as to cover the fluorescent material portion.

This indicates that, in Comparative example 1, gaps in the aggregate of the fluorescent particles 11 are filled with the glass material 12 such that the total volume of the volume of the glass material 12 and the volume of the fluorescent particles 11 is more than the envelope volume of the aggregate of the fluorescent particles 11.

Comparative example 2

Comparative example 2 is a comparative example that corresponds to Example 3 above. Comparative example 2 is the same as Example 3 except that the amount of the sol-gel solution dropped on the substrate 13 with a micropipette is set to 20 $\mu$l. Thus, in terms of the other points, the wavelength conversion member 10 is produced under the same production conditions as in Example 3.

As in Comparative example 1, the aggregate of the fluorescent particles 11 obtained in Comparative example 2 became separated so easily that the wavelength conversion member 10 was difficult to handle in the optical measurements. As in Example 1, the tape test was performed. As a result, a portion (corresponding to an area of 90% or more) of the fluorescent film 14 became separated from the substrate 13.

The thickness of the fluorescent film 14 having become separated was measured with a laser microscope. As a result, the thickness was found to be non-uniform and considerably varied. Specifically, in the fluorescent film 14, a thick portion had a thickness of about 40 $\mu$m and a thin portion had a thickness of about 20 $\mu$m.

In addition, as in Comparative example 1, the fluorescent film 14 having become separated was subjected to the surface observation with the SEM and the cross-sectional EDX measurement. The result in Comparative example 3 indicates that, as in Comparative example 1, gaps in the aggregate of the fluorescent particles 11 are filled with the glass material 12 such that the total volume of the volume of the glass material 12 and the volume of the fluorescent particles 11 is more than the envelope volume of the aggregate of the fluorescent particles 11.

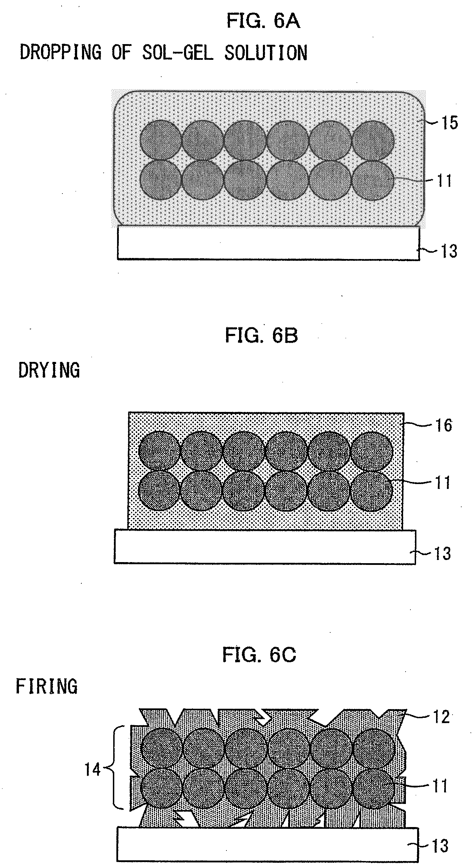

Hereinafter, referring to Figs. 6A to 7C, the reason why Comparative examples above are different from Examples above in terms of adhesion between the fluorescent film 14 and the substrate 13 (that is, difference in the results of the tape test) will be described.

Figs. 6A to 6C are schematic views illustrating production steps from dropping of the sol-gel solution to firing in Comparative examples. Fig. 6A illustrates a step of dropping a sol-gel solution 15 on the substrate 13. Fig. 6B illustrates a step of drying the sol-gel solution 15 on the substrate 13 to form a precursor 16 of the glass material 12. Fig. 6C illustrates a step of firing the precursor 16 of the glass material 12 to form the glass material 12.

In Comparative examples, as illustrated in Fig. 6A, an excess amount of the sol-gel solution 15 is dropped on the substrate 13, compared with Examples. As a result, as illustrated in Fig. 6B, after the sol-gel solution 15 is dried, an excess amount of the precursor 16 of the glass material 12 is formed on the surface of the aggregate of the fluorescent particles 11.

Subsequently, the precursor 16 of the glass material 12 is fired. Because of, for example, shrinkage of the precursor 16 itself and a difference in heat shrinkage ratio between the substrate 13 and the precursor 16, as illustrated in Fig. 6C, a large number of cracks are generated in the resultant glass material 12. In addition, the fluorescent particles 11 are not bonded to the substrate 13.

In summary, in Comparative examples, the fluorescent film 14 is formed as an unfixed film that is not bonded to the substrate 13. Accordingly, separation easily occurs at the interface between the fluorescent film 14 and the substrate 13.

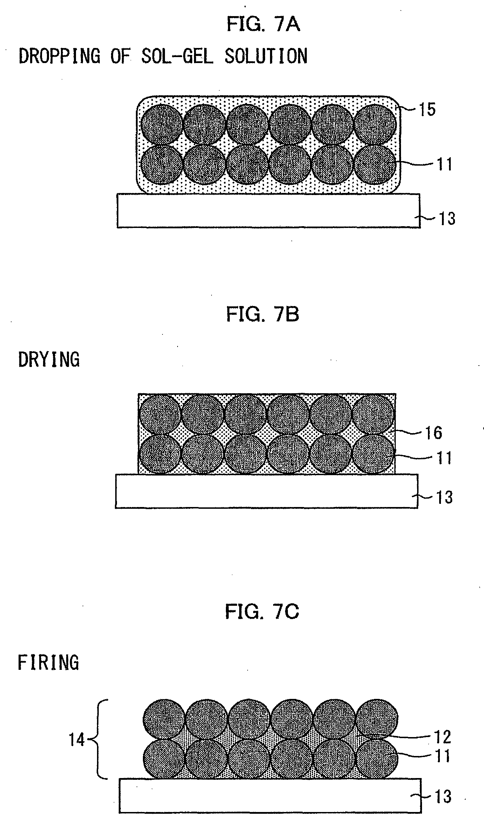

Figs. 7A to 7C are schematic views illustrating production steps from dropping of the sol-gel solution to firing in Examples. Fig. 7A illustrates a step of dropping the sol-gel solution 15 on the substrate 13. Fig. 7B illustrates a step of drying the sol-gel solution 15 on the substrate 13 to form the precursor 16 of the glass material 12. Fig. 7C illustrates a step of firing the precursor 16 of the glass material 12 to form the glass material 12.

Unlike Comparative examples, in Examples, as illustrated in Fig. 7A, an appropriate amount of the sol-gel solution 15 is dropped on the substrate 13. As a result, as illustrated in Fig. 7B, after the sol-gel solution 15 is dried, an excess amount of the precursor 16 of the glass material 12 is not formed on the surface of the aggregate of the fluorescent particles 11.

Accordingly, as illustrated in Fig. 7C, cracks are not generated in the resultant glass material 12. In addition, the fluorescent particles 11 are bonded to the substrate 13 and hence the fluorescent film 14 is formed as a film that is bonded to the substrate 13. Thus, the adhesion between the fluorescent film 14 and the substrate 13 is sufficiently high.

In Examples, the precursor 16 of the glass material 12 serves as an adhesive for bonding together the substrate 13 and the aggregate of the fluorescent particles 11. As a result, in Examples, the fluorescent film 14 is strongly bonded to the substrate 13.

Examples 4 to 9

The production conditions in Examples 4 and 5 are the same as those in Example 1. The production conditions in Examples 6 to 9 are the same as those in Example 1 except for the following two points: (i) the mass of the fluorescent particles 11 added to 100 ml of ethanol and (ii) the amount of the sol-gel solution dropped on the substrate 13 with a micropipette.

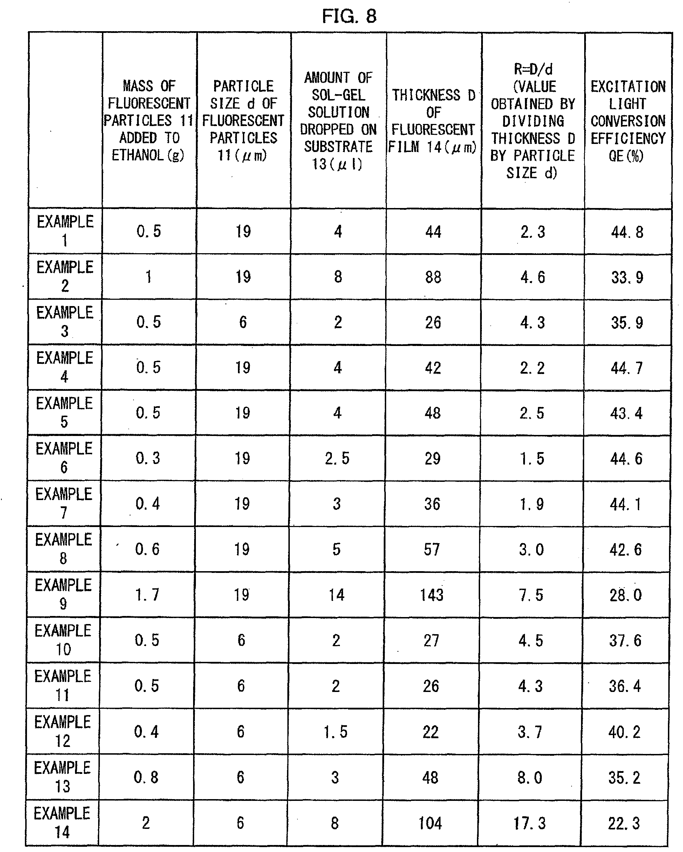

Fig. 8 below describes the mass of the fluorescent particles 11 and the amount of the sol-gel solution in Examples 4 to 9. Fig. 8 is a table summarizing the production conditions and evaluation results of Examples 1 to 14.

In Examples 6 to 9, the wavelength conversion members 10 are produced under the same production conditions as in Example 1 except for the mass of the fluorescent particles 11 and the amount of the sol-gel solution. That is, in Examples 4 to 9, the particle size d of the fluorescent particles 11 is the same as that of Example 1 (that is, 19 μm).

As in Example 1, in Examples 4 to 9, the wavelength conversion members 10 are also produced under appropriate control of the amount of the sol-gel solution dropped. Thus, gaps in the aggregate of the fluorescent particles 11 are filled with the glass material 12 such that the total volume of the volume of the glass material 12 and the volume of the fluorescent particles 11 is not more than the envelope volume of the aggregate of the fluorescent particles 11. As a result, also in Examples 4 to 9, the fluorescent film 14 that is strongly bonded to the substrate 13 is obtained.

Examples 10 to 14

The production conditions in Examples 10 and 11 are the same as those in Example 3. The production conditions in Examples 12 to 14 are the same as those in Example 3 except for the following two points: (i) the mass of the fluorescent particles 11 added to 100 ml of ethanol and (ii) the amount of the sol-gel solution dropped on the substrate 13 with a micropipette.

Fig. 8 describes, in addition to Examples 4 to 9, the mass of the fluorescent particles 11 and the amount of the sol-gel solution in Examples 10 to 14. In Examples 12 to 14, the wavelength conversion members 10 are produced under the same production conditions as in Example 3 except for the mass of the fluorescent particles 11 and the amount of the sol-gel solution. That is, in Examples 10 to 14, the particle size d of the fluorescent particles 11 is the same as that of Example 3 (that is, 6 μm).

As in Example 3, in Examples 10 to 14, the wavelength conversion members 10 are also produced under appropriate control of the amount of the sol-gel solution dropped. Thus, gaps in the aggregate of the fluorescent particles 11 are filled with the glass material 12 such that the total volume of the volume of the glass material 12 and the volume of the fluorescent particles 11 is not more than the envelope volume of the aggregate of the fluorescent particles 11. As a result, also in Examples 10 to 14, the fluorescent film 14 that is strongly bonded to the substrate 13 is obtained.

Evaluation of wavelength conversion members 10 in Examples 1 to 14

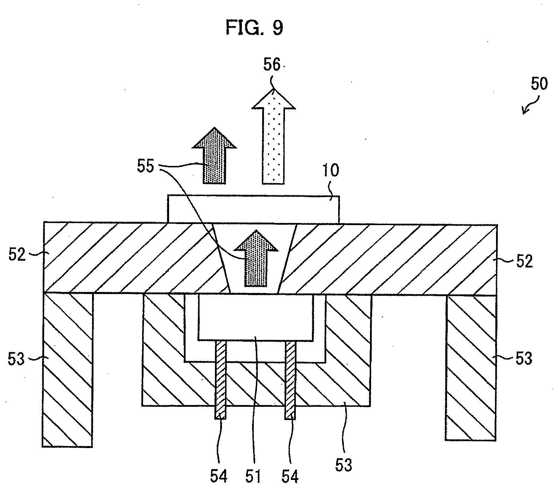

The wavelength conversion members 10 produced in Examples 1 to 14 above were evaluated in terms of excitation light conversion efficiency. Specifically, in the evaluation of excitation light conversion efficiency, each wavelength conversion member 10 was excited with a test device 50 (light-emitting device) illustrated in Fig. 9.

Fig. 9 illustrates an example of the configuration of the test device 50. The test device 50 is a light-emitting device used for evaluating the wavelength conversion members 10. The test device 50 includes a blue LED chip 51 (excitation light source) that emits excitation light 55. The blue LED chip 51 is supported by an aluminum plate 52 and a white base member 53. The blue LED chip 51 is equipped with electrodes 54.

The white base member 53 is formed of a white plastic material. In the aluminum plate 52, a through hole is formed through which the excitation light 55 passes. Over the through hole of the aluminum plate 52, the wavelength conversion member 10 is placed.

Power is supplied via the electrodes 54 to the blue LED chip 51, so that the blue LED chip 51 is operated. The blue LED chip 51 emits the excitation light 55 and the excitation light 55 reaches the wavelength conversion member 10.

The wavelength conversion member 10 converts the wavelength of a portion of the excitation light 55. As a result, the wavelength conversion member 10 emits fluorescence 56. The remaining portion of the excitation light 55 whose wavelength is not converted by the wavelength conversion member 10 passes through the wavelength conversion member 10. Hereinafter, processes for evaluating the excitation light conversion efficiency will be described.

The test device 50 has the following configuration: the excitation light 55 is applied on the substrate 13 side of the wavelength conversion member 10 (that is, the excitation light 55 is applied to the wavelength conversion member 10 through the substrate 13).

This is because heat generated upon reception of the excitation light 55 in the wavelength conversion member 10 is effectively dissipated by using the thermal conductivity of the substrate 13. This configuration allows suppression of thermal degradation of the wavelength conversion member 10.

However, the excitation light 55 is not necessarily applied on the substrate 13 side of the wavelength conversion member 10. For example, the excitation light 55 may be applied on a side of the wavelength conversion member 10, the side being opposite to the substrate 13.

First process: measurement of emission spectrum of fluorescence 56

The test device 50 was placed within an integrating sphere having an internal diameter of 30 cm and connected to a spectrophotometer (MCPD-2000, manufactured by Otsuka Electronics Co., Ltd.). The blue LED chip 51 was operated at an operation current of 20 mA and an operation voltage of 3.2 V. The emission spectrum D (λ) of the fluorescence 56 emitted from the wavelength conversion member 10 was measured.

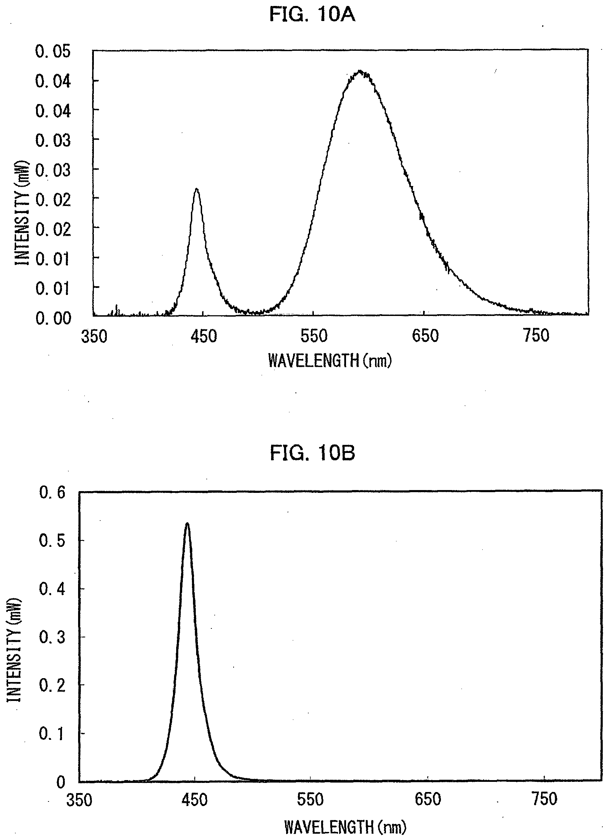

Fig. 10A is a graph of the emission spectrum D (λ) of the fluorescence 56 in Example 1. The abscissa axis of the graph indicates the wavelength λ (nm) of the fluorescence 56. The ordinate axis of the graph indicates the optical power intensity (mW) of the fluorescence 56.

Second process: measurement of emission spectrum of excitation light 55

The wavelength conversion member 10 was removed from the test device 50. A glass substrate having no fluorescent film was placed at the position where the wavelength conversion member 10 had been placed.

The test device 50 was then placed within the above-described integrating sphere. Subsequently, the blue LED chip 51 was operated under the same conditions as in the first process. The emission spectrum E (λ) of the excitation light 55 emitted from the blue LED chip 51 was measured.

Fig. 10B is a graph of the emission spectrum E (X) of the excitation light 55. The abscissa axis of the graph indicates the wavelength λ (nm) of the excitation light 55. The ordinate axis of the graph indicates the optical power intensity (mW) of the excitation light 55. The emission spectrum E (λ) of the excitation light 55 is the same in Examples 1 to 14.

Third process: calculation of excitation light conversion efficiency

In the emission spectrum D (λ) obtained in the first process, a portion of the emission spectrum in the wavelength range of 470 nm $\leq$ λ $\leq$ 800 nm is referred to as PH (λ); and another portion of the emission spectrum in the wavelength range of λ < 470 nm is referred to as TE (λ).

The emission spectrum PH (λ) relates to a range of wavelengths to which the wavelength conversion member 10 can convert the wavelength of the excitation light 55. The emission spectrum TE (λ) relates to a wavelength range in which the wavelength conversion member 10 does not convert the wavelength of the excitation light 55, that is, the wavelength conversion member 10 allows the excitation light 55 to pass therethrough.

The intensity of optical power indicated by the ordinate axis of the graph is converted into the number of photons in terms of emission spectrum PH (λ) and TE (λ). Similarly, in terms of emission spectrum E (λ) in the second process, the intensity of optical power indicated by the ordinate axis of the graph is converted into the number of photons.

The excitation light conversion efficiency QE of the wavelength conversion member 10 is calculated by a formula (1) below. Fig. 8 describes values of excitation light conversion efficiency QE in Examples 1 to 14.

$$QE = \frac{\int PH(\lambda)d\lambda}{\int E(\lambda)d\lambda - \int TE(\lambda)d\lambda} \qquad (1)$$

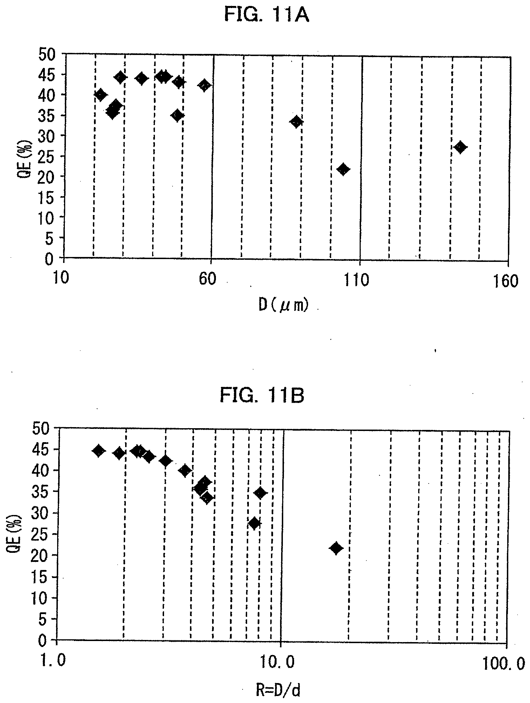

Fig. 11A is a graph indicating the dependency of the excitation light conversion efficiency QE of the wavelength conversion member 10 on the thickness D of the fluorescent film 14. The abscissa axis of the graph indicates the thickness D (μm). The ordinate axis of the graph indicates the excitation light conversion efficiency QE (%).

Fig. 11B is a graph indicating the dependency of the excitation light conversion efficiency QE of the wavelength conversion member 10 on R = D/d (in other words, a value obtained by dividing the thickness D of the fluorescent film 14 by the particle size d of the fluorescent particles 11). The abscissa axis of the graph indicates the value of R. The ordinate axis of the graph indicates the excitation light conversion efficiency QE (%).

Fig. 11A indicates that, when the thickness D is small, a high value of the excitation light conversion efficiency QE tends to be achieved. Fig. 11B indicates that, when the value of R is small (in other words, when the number of the fluorescent particles 11 deposited on the substrate 13 is small), a high value of the excitation light conversion efficiency QE tends to be achieved.

Specifically, Figs. 11A and 11B indicate that, when the thickness D is 60 μm or less and the value of R is 3 or less, an excitation light conversion efficiency QE that is very high of about 35% or more is achieved.

In general, in a typical wavelength conversion member in which fluorescent particles are dispersed in a resin material such as silicone, the thickness of a resin layer in which the fluorescent material is dispersed is about 1 mm. Assuming that the fluorescent particles have a particle size of about 10 μm or more and about 20 μm or less, the value obtained by dividing the thickness of the resin layer in which the fluorescent material is dispersed by the particle size of the fluorescent particles is about 50 or more and about 100 or less.

This value is much larger than the value of R in an embodiment according to the present disclosure. That is, the specific range of the thickness D (60 μm or less) and the specific range of R (3 or less), which have been found to provide a higher QE by the inventors of the present disclosure, are considerably departed from common general technical knowledge.

In other words, the specific range of the thickness D and the specific range of R according to an embodiment of the present disclosure are derived from the structure of the wavelength conversion member 10 in which the fluorescent particles 11 are deposited at a very high density onto the substrate 13, the structure being unique to an embodiment of the present disclosure. The specific range of the thickness D and the specific range of R according to an embodiment of the present disclosure have been newly found by the inventors as a result of repeated production and evaluation of trial products of the wavelength conversion member 10.

In the test device 50, the excitation light 55 may be applied on the substrate 13 side of the wavelength conversion member 10.

In such a case where the excitation light 55 is applied on the substrate 13 side of the wavelength conversion member 10, excessive light scattering caused by the fluorescent particles 11 is suppressed and, as a result, the excitation light conversion efficiency is expected to become high, compared with another case where the excitation light 55 is applied on a side of the wavelength conversion member 10, the side being opposite to the substrate 13.

Advantages of wavelength conversion member 10

The wavelength conversion member 10 of the present embodiment has the following configuration: the glass material 12 fills gaps in the aggregate of the fluorescent particles 11 such that the total volume of the volume of the glass material 12 and the volume of the fluorescent particles 11 is not more than the envelope volume of the aggregate of the fluorescent particles 11.

Since the wavelength conversion member 10 has this configuration, the fluorescent particles 11 can be bonded to the substrate 13. As a result, the fluorescent film 14 and the substrate 13 can be strongly bonded together. Thus, the wavelength conversion member 10 having a high mechanical strength is provided.

Since the wavelength conversion member 10 has this configuration, when the excitation light 55 (or excitation light 24) passes through the aggregate of the fluorescent particles 11 in the wavelength conversion member 10, an excitation light conversion efficiency QE that is high is achieved.

The inventors performed production and evaluation of trial products of the wavelength conversion member 10. As a result, the inventors have found the following finding: in the case where a small number of the fluorescent particles 11 having a large particle size are deposited onto the substrate 13, an excitation light conversion efficiency QE that is high is achieved.

In particular, by producing the wavelength conversion member 10 such that the value of R (obtained by dividing the thickness D of the fluorescent film 14 by the particle size d of the fluorescent particles 11) is 3 or less, an excitation light conversion efficiency QE that is high can be achieved.

Second embodiment

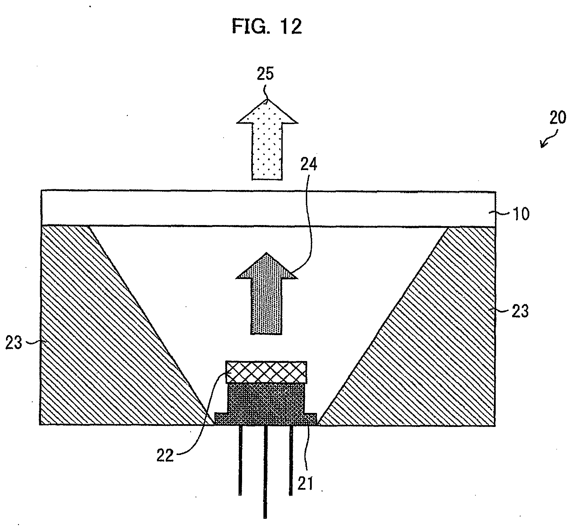

Hereinafter, a second embodiment according to the present disclosure will be described with reference to Fig. 12. For simplicity, the same members in terms of function as in the above-described embodiment are denoted by like reference numerals and descriptions of these members are omitted.

Light-emitting device 20

Fig. 12 is a sectional view of a light-emitting device 20. Hereinafter, the light-emitting device 20 including the above-described wavelength conversion member 10 will be described. The light-emitting device 20 includes the wavelength conversion member 10, a laser element 21 (excitation light source), a lens 22, and a support part 23.

The laser element 21 is an excitation light source that emits excitation light 24. Within the laser element 21, an InGaAlN-crystal nitride laser chip is contained. This laser chip is electrically connected to an external constant-voltage power supply (not shown).

The lens 22 is disposed on the light emission surface of the laser element 21. The lens 22 defines the range of space through which the excitation light 24 emitted from the laser element 21 passes. The support part 23 is a metal part disposed for supporting the wavelength conversion member 10 and the laser element 21. The laser element 21 is bonded to the support part 23.

In the light-emitting device 20, the excitation light 24 emitted from the laser element 21 enters the wavelength conversion member 10. The excitation light 24 excites the fluorescent particles 11 dispersed within the wavelength conversion member 10. Thus, in the wavelength conversion member 10, the excitation light 24 is converted to fluorescence 25 having a longer wavelength. The fluorescence 25 is emitted from the light-emitting device 20.

Regarding the InGaAlN-crystal nitride laser chip, by changing the composition of the constituent materials of, for example, a light-emitting layer, the emission peak wavelength can be changed in a range of 300 nm or more and 500 nm or less.

In particular, the emission peak wavelength may be set in a range of 350 nm or more and 470 nm or less. This is because this wavelength range substantially agrees with a range of a wavelength at which a peak value of the excitation spectrum of an oxynitride fluorescent material or a nitride fluorescent material is obtained (that is, a wavelength of excitation light that provides the maximum wavelength conversion efficiency).

Accordingly, by setting the emission peak wavelength so as to be in the range of 350 nm or more and 470 nm or less, a wavelength conversion efficiency that is high can be achieved in the wavelength conversion member 10. Thus, the light emission efficiency of the light-emitting device 20 can be increased. The present embodiment employs, as the excitation light 24, blue laser light having an emission peak wavelength in the range of 440 nm or more and 450 nm or less.

By changing the mixing ratios of different fluorescent particles 11, the color of light emitted from the light-emitting device 20 can be adjusted. For example, colors of light emitted from different fluorescent particles 11 can be combined, so that white light can be emitted from the light-emitting device 20. Such light-emitting devices 20 may be applied to illumination devices, displays, and the like. Examples of such light-emitting devices 20 will be described in third and fourth embodiments below.

In general, in the case where a semiconductor light-emitting element that emits high-intensity short-wavelength excitation light, such as a nitride laser chip, is applied to a light-emitting device, degradation of resin in which fluorescent particles are dispersed in the wavelength conversion member has been problematic.

In contrast, in the light-emitting device 20 according to the present embodiment, the substrate of the wavelength conversion member 10 is formed of glass, which is chemically stable. As a result, the light-emitting device 20 has a longer longevity than existing light-emitting devices.

Specifically, the light-emitting device 20 was evaluated in terms of change in the luminous intensity between initiation of operation and after the lapse of 3000 or more hours of operation. As a result, the change was found to be a very small value of 3% or less. Accordingly, it has been demonstrated that the light-emitting device 20 has a much longer longevity than existing light-emitting devices.

Advantages of light-emitting device 20

As described above, by applying the wavelength conversion member 10 to the light-emitting device 20, a light-emitting device having a high emission efficiency and a long longevity can be provided.

Third embodiment

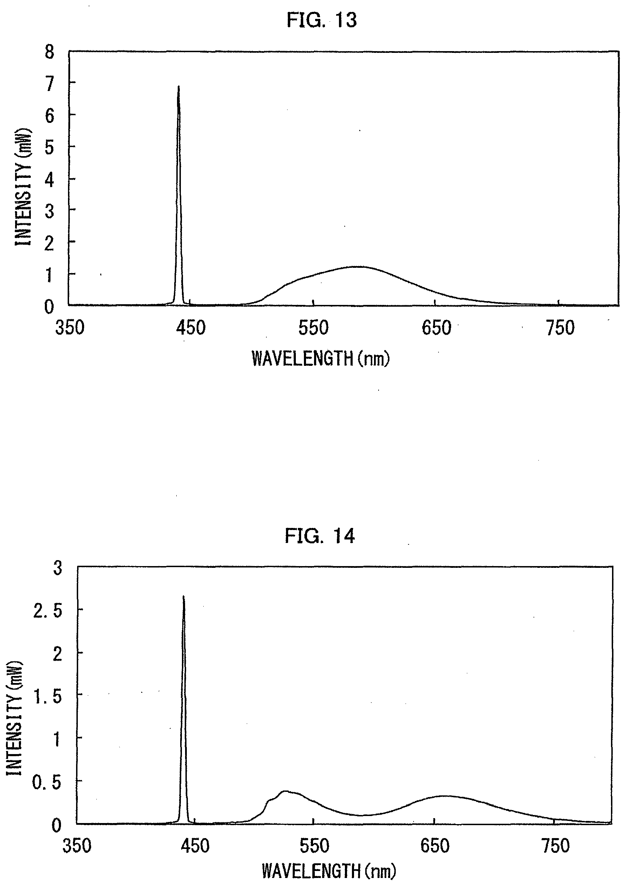

Hereinafter, a third embodiment according to the present disclosure will be described with reference to Fig. 13. For simplicity, the same members in terms of function as in the above-described embodiments are denoted by like reference numerals and descriptions of these members are omitted.

The above-described first embodiment describes an example case in which the Eu-activated $\alpha$-SiAlON fluorescent material is used as a material of the fluorescent particles 11. On the other hand, the present embodiment employs, as the material of the fluorescent particles 11, a material different from that in the first embodiment.

Production example 2: Eu-activated $\beta$-SiAlON fluorescent material

Production example 2 is intended to produce a Eu-activated $\beta$-SiAlON fluorescent material in which a material represented by a composition formula of $Si_{6-z'}Al_{z'}O_{z'}N_{8-z'}$, where $z' = 0.06$ is doped with Eu at 0.10 at%.

Raw material powders are sifted through a sieve having an opening of 45 $\mu$m and weighed to thereby achieve the following composition: 93.59 mass% of metal Si powder, 5.02 mass% of aluminum nitride powder, and 1.39 mass% of europium nitride powder.

Subsequently, the raw material powders are mixed with a mortar and pestle composed of silicon nitride sinter for 10 or more minutes. As a result, a powder aggregate is obtained. The powder aggregate is dropped by gravity into a crucible having a diameter of 20 mm and a height of 20 mm and formed of boron nitride so that the powder aggregate is charged into the crucible.

Subsequently, the crucible is placed in a pressure electric furnace of graphite resistance heating type. In the pressure electric furnace, a diffusion pump is used to provide a vacuum firing atmosphere. The temperature of the pressure electric furnace is increased from room temperature to 800°C at a temperature increase rate of 500°C/h.

A nitrogen gas having a temperature of 800°C and a purity of 99.999 vol% is introduced into the pressure electric furnace so as to adjust the pressure to 0.5 MPa. Subsequently, the temperature of the pressure electric furnace is increased to 1300°C at a temperature increase rate of 500°C/h, further increased to 1600°C at a temperature increase rate of 1°C/min, and kept at 1600°C for 8 hours.

As a result of this heating treatment, a synthesis sample is generated in the crucible. The synthesis sample is ground with an agate mortar to thereby provide a powder sample.

The powder sample is heat-treated again. The powder sample having been fired at 1600°C is ground with a mortar and pestle composed of silicon nitride. Subsequently, the powder sample is dropped by gravity into a crucible having a diameter of 20 mm and a height of 20 mm and formed of boron nitride so that the powder sample is charged into the crucible.

Subsequently, the crucible is placed in a pressure electric furnace of graphite resistance heating type. In the pressure electric furnace, a diffusion pump is used to provide a vacuum firing atmosphere. The temperature of the pressure electric furnace is then increased from room temperature to 800°C at a temperature increase rate of 500°C/h.

A nitrogen gas having a temperature of 800°C and a purity of 99.999 vol% is introduced into the pressure electric furnace so as to adjust the pressure to 1 MPa. Subsequently, the temperature of the pressure electric furnace is increased to 1900°C at a temperature increase rate of 500°C/h and further kept at 1900°C for 8 hours.

As a result of this heating treatment, a fluorescent material sample is generated in the crucible. Subsequently, the fluorescent material sample is ground with an agate mortar and treated with a mixed acid (50% hydrofluoric acid and 70% nitric acid are mixed in a ratio of 1:1) at 60°C. The fluorescent material sample is washed with pure water and then sifted through a sieve having an opening of 10 $\mu$m, so that particles having a small particle size are removed. Thus, the fluorescent particles 11 are obtained as a fluorescent powder.

The fluorescent particles 11 were measured by XRD. As a result, it was confirmed that the fluorescent particles 11 had a $\beta$-SiAlON crystal structure.

When the fluorescent particles 11 were irradiated with light having a wavelength of 365 nm emitted from a lamp, it was confirmed that the fluorescent particles 11 emitted green light. In addition, the fluorescent particles 11 were measured by laser diffractometry and, as a result, found to have a particle size d of 16 $\mu$m.

Method for producing wavelength conversion member 10 of present embodiment

Hereinafter, a method for producing the wavelength conversion member 10 of the present embodiment will be described with reference to Example 15.

Example 15

In this Example, the Eu-activated $\alpha$-SiAlON fluorescent material obtained in Production example 1-1 of the first embodiment and the Eu-activated $\beta$-SiAlON fluorescent material obtained in Production example 2 of the present embodiment are mixed with a mass ratio of 50:50. Thus, a fluorescent material mixture serving as the fluorescent particles 11 is obtained.

The fluorescent particles 11, which constituted the fluorescent material mixture, were measured by laser diffractometry and, as a result, found to have a particle size d of 18 $\mu$m. The wavelength conversion member 10 was produced under the same production conditions as in Example 1 above except that the fluorescent material mixture was used as the fluorescent particles 11 added to 100 ml of ethanol.

In this Example, the fluorescent film 14 was measured with a laser microscope (manufactured by Keyence Corporation) and was found to have a thickness D of 42 $\mu$m.

Accordingly, in this Example,

$$R = 42 \ \mu m / 18 \ \mu m = 2.3.$$

In addition, as in Example 1, the tape test was performed. As a result, no separation of the fluorescent film 14 from the substrate 13 was observed. As in Example 1, the result of the cross-sectional EDX measurement indicates that gaps in the aggregate of the fluorescent particles 11 are filled with the glass material 12 such that the total volume of the volume of the glass material 12 and the volume of the fluorescent particles 11 is not more than the envelope volume of the aggregate of the fluorescent particles 11.

Light-emitting device 20 of present embodiment

In the present embodiment, the wavelength conversion member 10 produced in Example 15 was used and a light-emitting device 20 was produced as in the second embodiment. In the present embodiment, the emission peak wavelength of excitation light emitted from the laser element 21 was set to 440 nm. The light-emitting device 20 was operated such that the optical power of excitation light from the laser element 21 was set to 1 W.

Fig. 13 is a graph illustrating the emission spectrum of the light-emitting device 20 of the present embodiment. The light-emitting device 20 of the present embodiment emits white light having a luminous flux of 125 lm and a color temperature of 3,500 K. The light-emitting device 20 of the present embodiment is suitable for high-luminance lighting applications such as headlights and exterior illumination.

In the light-emitting device 20 of the present embodiment, the excitation light conversion efficiency QE of the wavelength conversion member 10 was evaluated and, as a result, the QE was found to be 40.3%. Thus, as in the first embodiment, in the wavelength conversion member 10 of the present embodiment, by setting the value of R so as to be 3 or less, an excitation light conversion efficiency that is high of 35% or more was achieved.

Fourth embodiment

Hereinafter, a fourth embodiment according to the present disclosure will be described with reference to Fig. 14. For simplicity, the same members in terms of function as in the above-described embodiments are denoted by like reference numerals and descriptions of these members are omitted.

In the present embodiment, the fluorescent particles 11 were formed of a material that is different from that of the first and third embodiments.

Production example 3: Eu-activated $CaAlSiN_3$ fluorescent material

Production example 3 is intended to produce a Eu-activated $CaAlSiN_3$ fluorescent material that is represented by a composition formula of $Ca_{0.992}Eu_{0.008}SiAlN_3$.

Raw material powders are weighed to thereby achieve the following composition: 33.9 mass% of $\alpha$ silicon nitride powder, 29.7 mass% of aluminum nitride powder, 35.6 mass% of calcium nitride powder, and 0.8 mass% of europium oxide powder.

Subsequently, the raw material powders are mixed with a mortar and pestle composed of silicon nitride sinter for 10 or more minutes. As a result, a powder aggregate is obtained.

The powder aggregate is dropped by gravity into a crucible having a diameter of 20 mm and a height of 20 mm and formed of boron nitride so that the powder aggregate is charged into the crucible. The steps of weighing, mixing, and shaping the powders are all performed within a glove box in which a nitrogen atmosphere having a water content of 1 ppm or less and an oxygen content of 1 ppm or less can be maintained.

Subsequently, the crucible is placed in a pressure electric furnace of graphite resistance heating type. A nitrogen gas having a temperature of 800°C and a purity of 99.999 vol% is introduced into the pressure electric furnace so as to adjust the pressure to 1 MPa. The temperature of the pressure electric furnace is increased to 1800°C at a temperature increase rate of 500°C/h and kept at 1800°C for 2 hours.

As a result of this heating treatment, a fluorescent material sample is generated in the crucible. Subsequently, the fluorescent material sample is ground with an agate mortar. A mixed acid (50% hydrofluoric acid and sulfuric acid prepared by diluting 36 N sulfuric acid 10-fold are mixed in a ratio of 1:3) is diluted 10-fold with pure water to thereby prepare a solution. Subsequently, the ground sample is added to this solution and treated at 60°C.

The fluorescent material sample is washed with pure water and then sifted through a sieve having an opening of 10 $\mu$m, so that particles having a small particle size are removed. Thus, the fluorescent particles 11 are obtained as a fluorescent powder.

The fluorescent particles 11 were measured by XRD using Cu-$K_\alpha$ radiation. As a result, it was confirmed that the fluorescent particles 11 had a CaAlSiN$_3$ crystal structure.

When the fluorescent particles 11 were irradiated with light having a wavelength of 365 nm emitted from a lamp, it was confirmed that the fluorescent particles 11 emitted red light. In addition, the fluorescent particles 11 were measured by laser diffractometry and, as a result, found to have a particle size d of 15 $\mu$m.

Method for producing wavelength conversion member 10 of present embodiment

Hereinafter, a method for producing the wavelength conversion member 10 of the present embodiment will be described with reference to Example 16.

Example 16

In this Example, the Eu-activated $\beta$-SiAlON fluorescent material obtained in Production example 2 of the second embodiment and the Eu-activated CaAlSiN$_3$ fluorescent material obtained in Production example 3 of the present embodiment are mixed with a mass ratio of 80:20. Thus, a fluorescent material mixture serving as the fluorescent particles 11 is obtained.

The fluorescent particles 11, which constituted the fluorescent material mixture, were measured by laser diffractometry and, as a result, found to have a particle size d of 16 $\mu$m. The wavelength conversion member 10 was produced under the same production conditions as in Example 1 above except that the fluorescent material mixture was used as the fluorescent particles 11 added to 100 ml of ethanol, the mass of the fluorescent particles 11 was set to 0.5 g, and the amount of the sol-gel solution dropped was set to 3.5 $\mu$l.

In this Example, the fluorescent film 14 was measured with a laser microscope (manufactured by Keyence Corporation) and was found to have a thickness D of 40 $\mu$m.

Accordingly, in this Example,

$$R = 40 \ \mu m/16 \ \mu m = 2.5.$$

In addition, as in Example 1, the tape test was performed. As a result, no separation of the fluorescent film 14 from the substrate 13 was observed. As in Example 1, the result of the cross-sectional EDX measurement indicates that gaps in the aggregate of the fluorescent particles 11 are filled with the glass material 12 such that the total volume of the volume of the glass material 12 and the volume of the fluorescent particles 11 is not more than the envelope volume of the aggregate of the fluorescent particles 11.

Light-emitting device 20 of present embodiment

In the present embodiment, the wavelength conversion member 10 produced in Example 16 was used and a light-emitting device 20 was produced as in the second embodiment. In the present embodiment, the emission peak wavelength of excitation light emitted from the laser element 21 was set to 440 nm. The light-emitting device 20 was operated such that the optical power of excitation light from the laser element 21 was set to 1 W.

Fig. 14 is a graph illustrating the emission spectrum of the light-emitting device 20 of the present embodiment. The light-emitting device 20 of the present embodiment emits white light having a luminous flux of 52 1m and a color temperature of 7,000 K. The light-emitting device 20 of the present embodiment is suitable for display applications such as projectors and liquid crystal backlights.

In the light-emitting device 20 of the present embodiment, the excitation light conversion efficiency QE of the wavelength conversion member 10 was evaluated and, as a result, the QE was found to be 43.2%. Thus, as in the first embodiment, in the wavelength conversion member 10 of the present embodiment, by setting the value of R so as to be 3 or less, an excitation light conversion efficiency that is high of 35% or more was achieved.

Summary of embodiments

A wavelength conversion member (10) according to Embodiment 1 of the present disclosure includes a substrate (13) and a fluorescent film (14) that is disposed on the substrate and emits fluorescence (25, 56) upon reception of excitation light (24, 55), wherein the fluorescent film includes an aggregate of a plurality of fluorescent particles (11), the aggregate being formed as a result of contact among the fluorescent particles, and a glass material (12) filling gaps between the fluorescent particles in the aggregate, and a total volume of a volume of the glass material and a volume of the fluorescent particles in the fluorescent film is equal to or less than an envelope volume of the aggregate in the fluorescent film.

In this configuration, in the wavelength conversion member, gaps in the aggregate of the fluorescent particles are filled with the glass material such that the total volume of the volume of the glass material and the volume of the fluorescent particles is equal to or less than the envelope volume of the aggregate of the fluorescent particles. Thus, it is suppressed that an excess amount of the glass material is present on the surface of the aggregate of the fluorescent particles.

As a result, as illustrated in Fig. 7C, the fluorescent particles are disposed so as to be bonded to the substrate. Thus, the fluorescent film is formed as a film that is bonded to the substrate.

Accordingly, the fluorescent film is formed so as to have a sufficiently high adhesion to the substrate, compared with the case where gaps in an aggregate of fluorescent particles are filled with a glass material such that the total volume of the volume of the glass material and the volume of the fluorescent particles is more than the envelope volume of the aggregate of the fluorescent particles.

Thus, an embodiment of the present disclosure can provide a wavelength conversion member having a high mechanical strength.

According to Embodiment 2 of the present disclosure, in the wavelength conversion member according to Embodiment 1, the fluorescent film may have a thickness (D) of 60 μm or less.

In this configuration where the fluorescent film has a thickness of 60 μm or less, as illustrated in Fig. 11A, the wavelength conversion member can have an excitation light conversion efficiency (QE) that is high.

On the other hand, in existing wavelength conversion members, a resin layer in which fluorescent material is dispersed has a thickness of about 1 mm. Accordingly, the above-described thickness of the fluorescent film according to an embodiment of the present disclosure is considerably departed from common general technical knowledge.

According to Embodiment 3 of the present disclosure, in the wavelength conversion member according to Embodiment 1 or 2, the fluorescent particles may have a particle size (d) of 1 μm or more and 50 μm or less.

In the wavelength conversion member having this configuration, the fluorescent particles have a high light emission efficiency and handling of the fluorescent particles is facilitated.

According to Embodiment 4 of the present disclosure, in the wavelength conversion member according to any one of Embodiments 1 to 3, the fluorescent particles may have a particle size of 5 μm or more and 25 μm or less.

In the wavelength conversion member having this configuration, the fluorescent particles have a higher light emission efficiency and handling of the fluorescent particles is further facilitated.

More specifically, by setting the particle size of the fluorescent particles to 5 μm or more, the fluorescent particles have very high crystallinity and the light emission efficiency of the fluorescent particles can be enhanced. By setting the particle size of the fluorescent particles to 25 μm or less, handling of the fluorescent particles 11 is particularly facilitated, so that the fluorescent film can be formed so as to have a more uniform thickness.

According to Embodiment 5 of the present disclosure, in the wavelength conversion member according to any one of Embodiments 1 to 4, the fluorescent particles may be formed of an oxynitride fluorescent material or a nitride fluorescent material.

As described above, the glass material is used to fill gaps in the aggregate of the fluorescent particles. In order to form glass, a high-temperature process at 200°C or more is performed.

In the configuration where an oxynitride fluorescent material or a nitride fluorescent material, which is highly heat resistant, is used as the fluorescent particles, the high-temperature process for producing the wavelength conversion member can be suitably performed.

According to Embodiment 6 of the present disclosure, in the wavelength conversion member according to any one of Embodiments 1 to 5, the glass material may be silica glass.

In this configuration where silica glass, which has high thermal stability and high chemical stability, is used as the glass material, the wavelength conversion member can have enhanced thermal stability and enhanced chemical stability.

According to Embodiment 7 of the present disclosure, in the wavelength conversion member according to any one of Embodiments 2 to 6, a value (R = D/d) obtained by dividing the thickness of the fluorescent film by a particle size of the fluorescent particles may be 3 or less.

In such a configuration where the fluorescent film has a thickness of 60 μm or less and the value (value of R) obtained by dividing the thickness of the fluorescent film by the particle size of the fluorescent particles is 3 or less, the wavelength conversion member can have an excitation light conversion efficiency that is high.

On the other hand, in existing wavelength conversion members, the value obtained by dividing the thickness of a resin layer in which fluorescent material is dispersed by the particle size of fluorescent particles (the fluorescent material) is about 50 or more and about 100 or less. Accordingly, the above-described value of R according to an embodiment of the present disclosure is considerably departed from common general technical knowledge.

In other words, the specific range of the thickness D and the specific range of R according to an embodiment of the present disclosure are derived from the structure of the wavelength conversion member according to an embodiment of the present disclosure in which the fluorescent particles are deposited at a very high density onto the substrate. The specific range of the thickness D and the specific range of R according to an embodiment of the present disclosure have been newly found by the inventors as a result of repeated production and evaluation of trial products of wavelength conversion members.

A light-emitting device (light-emitting device 20 or test device 50) according to Embodiment 8 of the present disclosure may include the wavelength conversion member according to Embodiment 7 and an excitation light source (laser element 21 or blue LED chip 51) configured to apply the excitation light to the wavelength conversion member.

When this configuration is employed, a light-emitting device including the wavelength conversion member having an excitation light conversion efficiency that is high can be produced. As a result, a light-emitting device having a high light emission efficiency and long longevity can be provided.

In a light-emitting device according to Embodiment 9 of the present disclosure, the excitation light may be applied to the wavelength conversion member through the substrate.

In this configuration, heat generated upon reception of the excitation light in the wavelength conversion member can be effectively dissipated by using the thermal conductivity of the substrate, compared with the case where the excitation light is applied on a side of the wavelength conversion member, the side being opposite to the substrate.

In addition, in the above-described configuration, excessive light scattering caused by the fluorescent particles is suppressed and, as a result, the excitation light conversion efficiency is expected to become high, compared with the case where the excitation light is applied on a side of the wavelength conversion member, the side being opposite to the substrate.

A method for producing a wavelength conversion member according to Embodiment 10 of the present disclosure is a method for producing a wavelength conversion member including a substrate and a fluorescent film that is disposed on the substrate and emits fluorescence upon reception of excitation light, the fluorescent film including an aggregate of a plurality of fluorescent particles, the aggregate being formed as a result of contact among the fluorescent particles, and a glass material filling gaps between the fluorescent particles in the aggregate, the method including: depositing the aggregate onto the substrate; filling the gaps with a precursor (16) of the glass material; and heating the precursor to form the glass material, wherein the wavelength conversion member is produced such that a total volume of a volume of the glass material and a volume of the fluorescent particles in the fluorescent film is equal to or less than an envelope volume of the aggregate in the fluorescent film.

This configuration allows production of the wavelength conversion member according to Embodiment 1.

Appendix

The present disclosure also encompasses embodiments described below.

A wavelength conversion member according to an embodiment of the present disclosure at least includes a substrate and a fluorescent film that includes fluorescent particles and a light-transmissive substance, wherein the fluorescent particles form an aggregate, the light-transmissive substance is glass filling gaps in the aggregate of the fluorescent particles, the light-transmissive substance is used to fill the gaps such that an envelope volume of the light-transmissive substance is not more than an envelope volume of the aggregate of the fluorescent particles.

In a wavelength conversion member according to an embodiment of the present disclosure, the fluorescent particles have a particle size of 1 to 50 μm.

In a wavelength conversion member according to an embodiment of the present disclosure, the fluorescent particles have a particle size of 5 to 25 μm.

In a wavelength conversion member according to an embodiment of the present disclosure, the film of the aggregate of the fluorescent particles has a thickness of 60 μm or less.

In a wavelength conversion member according to an embodiment of the present disclosure, the fluorescent particles are formed of an oxynitride fluorescent material or a nitride fluorescent material.

In a wavelength conversion member according to an embodiment of the present disclosure, the glass is silica glass.

A light-emitting device according to an embodiment of the present disclosure has a configuration in which excitation light emitted from a semiconductor light-emitting element is applied to the above-described wavelength conversion member through the substrate and illumination light is emitted from the aggregate of the fluorescent particles, wherein a value obtained by dividing the thickness of the fluorescent film by a particle size of the fluorescent particles is 3 or less.

The present disclosure is applicable to a wavelength conversion member and a light-emitting device including a wavelength conversion member.

**Claims**

1. A wavelength conversion member (10) comprising:

   a substrate (13); and
   a fluorescent film (14) that is disposed on the substrate (13) and emits fluorescence upon reception of excitation light,
   **characterized in that**
   the fluorescent film (14) includes an aggregate of a plurality of fluorescent particles (11), the aggregate being formed as a result of contact among the fluorescent particles (11), and a glass material (12) filling gaps between the fluorescent particles (14) in the aggregate,
   the fluorescent film (14) has a thickness of 60 $\mu$m or less, and
   a total volume of a volume of the glass material (12) and a volume of the fluorescent particles (11) in the fluorescent film (14) is equal to or less than an envelope volume of the aggregate in the fluorescent film (14), corresponding to the minimum volume of an imaginary rectangular parallelepiped that contains all the fluorescent particles (11) present within the fluorescent film (14), and
   a value obtained by dividing the thickness of the fluorescent film (14) by a particle size of the fluorescent particles (11) is 3 or less.

2. The wavelength conversion member (10) according to Claim 1, wherein the fluorescent particles (11) have a particle size of 1 $\mu$m or more and 50 $\mu$m or less.

3. The wavelength conversion member (10) according to Claim 1, wherein the fluorescent particles (11) have a particle size of 5 $\mu$m or more and 25 $\mu$m or less.

4. The wavelength conversion member (10) according to Claim 1, wherein the fluorescent particles (11) are formed of an oxynitride fluorescent material or a nitride fluorescent material.

5. The wavelength conversion member (10) according to Claim 1, wherein the glass material (12) is silica glass.

6. A light-emitting device (20) comprising:

   the wavelength conversion member (10) according to Claim 1; and
   an excitation light source configured to apply the excitation light to the wavelength conversion member (10).

7. The light-emitting device (20) according to Claim 6, wherein the excitation light is applied to the wavelength conversion member (10) through the substrate (13).

**Patentansprüche**

1. Wellenlängenumsetzungselement (10), umfassend:

   ein Substrat (13); und
   einen fluoreszierenden Film (14), der auf dem Substrat (13) angeordnet ist und bei Empfang von Anregungslicht Fluoreszenz emittiert,
   **dadurch gekennzeichnet, dass**
   der fluoreszierende Film (14) eine Aggregation einer Vielzahl fluoreszierender Teilchen (11) umfasst, wobei die Aggregation als Folge eines Kontakts unter den fluoreszierenden Teilchen (11) gebildet ist, und ein Glasmaterial (12), das Lücken zwischen den fluoreszierenden Teilchen (11) in der Aggregation füllt,
   der fluoreszierende Film (14) eine Dicke von 60 $\mu$m oder weniger aufweist, und
   ein Gesamtvolumen eines Volumens des Glasmaterials (12) und eines Volumens der fluoreszierenden Teilchen (11) im fluoreszierenden Film (14) gleich einem oder geringer als ein Hüllvolumen der Aggregation im fluoreszierenden Film (14) ist, entsprechend dem minimalen Volumen eines imaginären rechteckigen Parallelepipeds, das all die innerhalb des fluoreszierenden Films (14) vorhandenen fluoreszierenden Teilchen (11) enthält, und
   ein durch Dividieren der Dicke des fluoreszierenden Films (14) durch eine Teilchengröße der fluoreszierenden Teilchen (11) erhaltener Wert 3 oder weniger beträgt.

2. Wellenlängenumsetzungselement (10) nach Anspruch 1, wobei die fluoreszierenden Teilchen (11) eine Teilchengröße von 1 $\mu$m oder mehr und 50 $\mu$m oder weniger aufweisen.

3. Wellenlängenumsetzungselement (10) nach Anspruch 1, wobei die fluoreszierenden Teilchen (11) eine Teilchengröße von 5 $\mu$m oder mehr und 25 $\mu$m oder weniger aufweisen.

4. Wellenlängenumsetzungselement (10) nach Anspruch 1, wobei die fluoreszierenden Teilchen (11) aus einem Oxynitrid-Fluoreszenzmaterial oder einem Nitrid-Fluoreszenzmaterial bestehen.

5. Wellenlängenumsetzungselement (10) nach Anspruch 1, wobei das Glasmaterial (12) Quarzglas ist.

6. Lichtemittierende Vorrichtung (20), umfassend:

   das Wellenlängenumsetzungselement (10) nach Anspruch 1; und
   eine Anregungslichtquelle, die dafür eingerichtet ist, das Anregungslicht auf das Wellenlängenumsetzungselement (10) anzuwenden.

7. Lichtemittierende Vorrichtung (20) nach Anspruch 6, wobei das Anregungslicht durch das Substrat (13) auf das Wellenlängenumsetzungselement (10) angewendet wird.

**Revendications**

1. Élément de conversion de longueur d'onde (10) comprenant :

   un substrat (13) ; et
   un film fluorescent (14) qui est disposé sur le substrat (13) et qui émet une fluorescence lors de la réception d'une lumière d'excitation, **caractérisé en ce que**
   le film fluorescent (14) comprend un agrégat d'une pluralité de particules fluorescentes (11), l'agrégat étant formé du fait du contact entre les particules fluorescentes (11), et un matériau de verre (12) remplissant les espaces entre les particules fluorescentes (11) dans l'agrégat,
   le film fluorescent (14) possède une épaisseur de 60 $\mu$m ou moins, et
   un volume total d'un volume du matériau de verre (12) et d'un volume des particules fluorescentes (11) dans le film fluorescent (14) est inférieur ou égal à un volume d'enveloppe de l'agrégat dans le film fluorescent (14), correspondant au volume minimum d'un parallélépipède rectangulaire imaginaire qui contient toutes les particules fluorescentes (11) présentes dans le film fluorescent (14), et
   une valeur obtenue en divisant l'épaisseur du film fluorescent (14) par une taille particulaire des particules fluorescentes (11) est 3 ou moins.

2. Élément de conversion de longueur d'onde (10) selon la revendication 1, dans lequel les particules fluorescentes (11) présentent une taille particulaire de 1 $\mu$m ou plus et de 50 $\mu$m ou moins.

3. Élément de conversion de longueur d'onde (10) selon la revendication 1, dans lequel les particules fluorescentes (11) présentent une taille particulaire de 5 $\mu$m ou plus et de 25 $\mu$m ou moins.

4. Élément de conversion de longueur d'onde (10) selon la revendication 1, dans lequel les particules fluorescentes (11) sont formées à partir d'un matériau fluorescent à base d'oxynitrure ou d'un matériau fluorescent à base de nitrure.

5. Élément de conversion de longueur d'onde (10) selon la revendication 1, dans lequel le matériau de verre (12) est un verre de silice.

6. Dispositif émetteur de lumière (20) comprenant :

   l'élément de conversion de longueur d'onde (10) selon la revendication 1 ; et
   une source de lumière d'excitation conçue pour appliquer la lumière d'excitation sur l'élément de conversion de longueur d'onde (10).

7. Dispositif émetteur de lumière (20) selon la revendication 6, dans lequel la lumière d'excitation est appliquée sur l'élément de conversion de longueur d'onde (10) à travers le substrat (13).

FIG. 1

FIG. 2

## FIG. 3A

## FIG. 3B

FLUORESCENT MATERIAL PORTION

GLASS PORTION    SUBSTRATE PORTION

## FIG. 4

## FIG. 5A

## FIG. 5B

FLUORESCENT MATERIAL PORTION

GLASS PORTION

## FIG. 6A

DROPPING OF SOL-GEL SOLUTION

—15
—11
—13

## FIG. 6B

DRYING

—16
—11
—13

## FIG. 6C

FIRING

—12
14{
—11
—13

## FIG. 7A

DROPPING OF SOL-GEL SOLUTION

## FIG. 7B

DRYING

## FIG. 7C

FIRING

## FIG. 8

| | MASS OF FLUORESCENT PARTICLES 11 ADDED TO ETHANOL (g) | PARTICLE SIZE d OF FLUORESCENT PARTICLES 11 ($\mu$m) | AMOUNT OF SOL-GEL SOLUTION DROPPED ON SUBSTRATE 13 ($\mu$l) | THICKNESS D OF FLUORESCENT FILM 14 ($\mu$m) | R=D/d (VALUE OBTAINED BY DIVIDING THICKNESS D BY PARTICLE SIZE d) | EXCITATION LIGHT CONVERSION EFFICIENCY QE (%) |
|---|---|---|---|---|---|---|
| EXAMPLE 1 | 0.5 | 19 | 4 | 44 | 2.3 | 44.8 |
| EXAMPLE 2 | 1 | 19 | 8 | 88 | 4.6 | 33.9 |
| EXAMPLE 3 | 0.5 | 6 | 2 | 26 | 4.3 | 35.9 |
| EXAMPLE 4 | 0.5 | 19 | 4 | 42 | 2.2 | 44.7 |
| EXAMPLE 5 | 0.5 | 19 | 4 | 48 | 2.5 | 43.4 |
| EXAMPLE 6 | 0.3 | 19 | 2.5 | 29 | 1.5 | 44.6 |
| EXAMPLE 7 | 0.4 | 19 | 3 | 36 | 1.9 | 44.1 |
| EXAMPLE 8 | 0.6 | 19 | 5 | 57 | 3.0 | 42.6 |
| EXAMPLE 9 | 1.7 | 19 | 14 | 143 | 7.5 | 28.0 |
| EXAMPLE 10 | 0.5 | 6 | 2 | 27 | 4.5 | 37.6 |
| EXAMPLE 11 | 0.5 | 6 | 2 | 26 | 4.3 | 36.4 |
| EXAMPLE 12 | 0.4 | 6 | 1.5 | 22 | 3.7 | 40.2 |
| EXAMPLE 13 | 0.8 | 6 | 3 | 48 | 8.0 | 35.2 |
| EXAMPLE 14 | 2 | 6 | 8 | 104 | 17.3 | 22.3 |

FIG. 9

## FIG. 10A

## FIG. 10B

FIG. 11A

FIG. 11B

FIG. 12

## FIG. 13

## FIG. 14

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10163535 A
- JP 2003258308 A
- JP 2011168627 A

- JP H0745189 A
- WO 2013144777 A1
- DE 102010042217 A1

**Non-patent literature cited in the description**

- **TAKUYA KITABATAKE ; TETSUO UCHIKOSHI ; FUMIO MUNAKATA ; YOSHIO SAKKA ; NAOTO HIROSAKI.** Optical and adhesive properties of composite silica-impregnated Ca-$\alpha$-SiAlON:Eu2+ phosphor films prepared on silica glass substrates. *Journal of the European Ceramic Society,* 2012, vol. 32, 1365-1369